# EUROPEAN PATENT SPECIFICATION

(11) **EP 4 016 728 B1**
(45) Date of publication and mention of the grant of the patent: **05.11.2025**
(21) Application number: 21197377.1
(22) Date of filing: 17.09.2021
(51) Int. Cl.: H01Q 1/22, H01Q 1/52, H01Q 5/335, H01Q 5/328, H01Q 9/42, H01Q 13/10, H01Q 21/28

(54) **ANTENNA ASSEMBLY WITH ISOLATION NETWORK**
ANTENNENANORDNUNG MIT ISOLATIONSNETZWERK
ENSEMBLE ANTENNE À RÉSEAU D'ISOLATION

(30) Priority: 21.12.2020 US 202017129705
(43) Date of publication of application: 22.06.2022
(73) Proprietor: INTEL Corporation, Santa Clara, CA 95054 (US)
(72) Inventor: THAKUR, Jayprakash, 560035 Bangalore (IN); TAMRAKAR, Maruti, 600127 Chennai (IN); GUPTA, Sagar, Ghaziabad (IN); SINGH, Rakhi, 226016 Lucknow (IN)
(74) Representative: Viering, Jentschura & Partner mbB Patent- und Rechtsanwälte

(56) References cited:
- WO-A1-2018/219070
- CN-A- 107 317 103
- CN-A- 110 224 226
- US-A1- 2018 048 052

## Description

### Field

Embodiments of the present invention relate generally to the technical field of wireless communications, and more particularly to antenna assemblies for wireless communication devices.

### Background

The background description provided herein is for the purpose of generally presenting the context of the disclosure. Work of the presently named inventors, to the extent it is described in this background section, as well as aspects of the description that may not otherwise qualify as prior art at the time of filing, are neither expressly nor impliedly admitted as prior art against the present disclosure. Unless otherwise indicated herein, the approaches described in this section are not prior art to the claims in the present disclosure and are not admitted to be prior art by inclusion in this section.

Recent development in wireless technologies (e.g., Wi-Fi 6E and 5G) require more than 6 antennas in a communication device. WO 2018/219070 A1, CN 107 317 103 A, and CN 110 224 226 A disclose examples of such communication devices. It can be challenging to place all the antennas in the device while providing good performance. For example, some systems (e.g., with lighter, thinner and/or bezel-less design) require a full metal chassis system with all the antennas on the base. Additionally, modern mobile devices have limited space available for antenna placement to achieve good performance. Furthermore, if the antennas are placed close to each other, it may yield poor isolation, which causes a drop in wireless throughput. It is also difficult to achieve good impedance matching for wide bandwidth if antennas are kept next to each other due to mutual coupling.

Furthermore, the frequency bandwidth of wireless technologies (e.g., Wi-Fi 6E and 5G) is also increasing with demand of higher data rate. In Wi-Fi 6E an additional frequency band is added (e.g., 5.925-7.125 GHz), and the Wi-Fi 6E operating band includes 2.4-2.5 GHz, 5.15-5.85 GHz and 5.925- 7.125 GHz. Similarly, 5G cellular wireless technology has also added additional frequency bands (e.g., 0.617-0.7 GHz, 3.3-6.0 GHz). The 5G wireless technology operating band is 0.617-0.96 GHz, 1.7-2.7 GHz, 3.3-5.0 GHz and 5.0-6.0 GHz).

Accordingly, modern communication devices may require multiple wideband antennas that are challenging to place in the device while providing good performance.

### Brief Description of the Drawings

Embodiments will be readily understood by the following detailed description in conjunction with the accompanying drawings. To facilitate this description, like reference numerals designate like structural elements. Embodiments are illustrated by way of example and not by way of limitation in the figures of the accompanying drawings.
Figure 1 schematically illustrates an antenna assembly including an isolation network between two antennas, in accordance with various embodiments.
Figure 2 illustrates an example antenna assembly in accordance with various embodiments.
Figures 3A, 3B, and 3C illustrate example implementations of an antenna, in accordance with various embodiments.
Figure 4A illustrates an example of a printed circuit board (PCB) antenna assembly with an isolation network, in accordance with various embodiments.
Figure 4B illustrates a front perspective view of an example of a laptop computer that includes the antenna assembly of Figure 4A, in accordance with various embodiments.
Figure 4C illustrates a rear perspective view of the laptop computer of Figure 4B with the rear cover removed to see internal components, in accordance with various embodiments.
Figure 4D illustrates a close-up view of a region of the laptop computer of Figure 4B-4C that includes an antenna assembly, in accordance with various embodiments.
Figure 5 illustrates another example implementation of an antenna assembly (e.g., including an aperture antenna) with an isolation network in a computer system, in accordance with various embodiments.
Figure 6 illustrates an example of a dual feed antenna with an isolation network, in accordance with various embodiments.
Figure 7 illustrates another antenna assembly (e.g., including F-shaped metal split (slot) antennas) with an isolation network, in accordance with various embodiments.
Figure 8 illustrates another antenna assembly (e.g., including L-shaped metal split (slot) antennas) with an isolation network, in accordance with various embodiments.
Figures 9A-9E illustrate various views of a computing device (e.g., a tablet computing device) that includes a plurality of antenna assemblies, in accordance with various embodiments. Figure 9A is a top view from a rear cover (A-cover) side of the computing device. Figures 9B and 9C are perspective views of respective ends of the computing device from the rear cover side. Figure 9D is a top view from the display side of the computing device, showing internal components thereof. Figure 9E shows close-up views of end regions of the view shown in Figure 9D.
Figure 10 illustrates an example of a computer platform in accordance with various embodiments.
Figure 11 illustrates example components of baseband circuitry and radio front end modules in accordance with various embodiments.

### Detailed Description

In the following detailed description, reference is made to the accompanying drawings that form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

Various embodiments herein include an antenna assembly with two or more antennas, and associated systems, devices, and methods. For example, an antenna assembly may include a first antenna and a second antenna coupled to a ground plane. The techniques described herein may be used with many different types of antennas, such as metal split antenna, slot antennas, metal ring antennas, printed circuit board (PCB) antennas, and/or flexible printed circuit board (FCP) antennas. For example, in some embodiments, the first and/or second antennas may be implemented by a chassis of an associated wireless communication device (e.g., portions of a metal chassis separated by one or more adjacent parting lines of a non-conductive material, such as plastic). Alternatively, or additionally, the first and/or second antennas may be implemented by a circuit board, such as a PCB and/or a FCP, and/or another suitable structure.

The antenna assembly may further include an isolation network coupled to the ground plane between the first and second antennas. The isolation network may include a conductive structure and an isolation circuit coupled between the conductive structure and the ground plane. The conductive structure may be at least partially located between conductive portions of the respective first and second antennas. In some embodiments, the conductive structure may include a first portion that is between the respective conductive portions of the first antenna and the second antenna, and a second portion to conductively couple the first portion to the isolation circuit, wherein a width of the first portion is greater than a width of the second portion. For example, the first portion and the second portion of the conductive structure may form a "T" shape. In some embodiments, the first and/or second portions may be implemented by a portion of the metal chassis (e.g., separated from the respective conductive portions of the first antenna and the second antenna by one or more parting lines), a PCB, and/or an FCP. For example, in some embodiments, the first portion may be implemented by the metal chassis and the second portion may be implemented by an FCP. However, according to the invention defined by the appended claims, the first and second portions are implemented by a portion of the metal chassis.

The isolation network may further include an isolation circuit coupled between the conductive structure and the ground plane. In some embodiments, the isolation circuit may include one or more resistors, capacitors, and/or inductors. For example, the isolation circuit may include a resistor, a capacitor, and/or an inductor coupled in parallel with one another and coupled between the conductive structure and the ground plane. In some embodiments, the isolation circuit may be implemented on a circuit board, such as an FCP (e.g., the same FCP that implements the second portion of the conductive structure).

In various embodiments, the first antenna and/or second antenna may further include a feed network to pass a radio frequency (RF) signal to or from a conductive antenna portion of the respective antenna. For example, the feed network may include a feed element (e.g., a conductor such as a conductive cable, trace, and/or FCP) to pass the RF signal to or from the conductive antenna portion, a first one of an inductor or capacitor between the feed element and an internal node of the feed network, and a second one of an inductor or capacitor (e.g., a capacitor when the first one is an inductor or an inductor when the first one is a capacitor) between the internal node and ground (e.g., the ground plane). The selection/configuration of the inductor and capacitor may be based on the frequency range to be handled by the respective antenna. The feed network may further include another capacitor coupled between the internal node and the conductive antenna portion. The feed network may enable the antennas to operate over a wider frequency band compared with prior techniques.

In various embodiments, the first and second antennas (and/or other antennas included in the antenna assembly) may be used to communicate on any suitable frequency range and/or wireless communication protocol. For example, the first and/or second antenna may be used for 5G cellular communications (e.g., 5G multiple input, multiple output (MIMO) 04, 5G MIMO 03, and/or 5G low band (e.g., 0.617-0.96 GHz)) and/or wireless local area network (WLAN, e.g., WiFi) communications (e.g., WiFi-6E and/or another present or future WLAN protocol). In some embodiments, one or more of the antennas may be used for multiple wireless communication protocols (e.g., both 5G MIMO 03 and WiFi-6E).

In various embodiments, the isolation network described herein improve isolation between the first and second antennas and/or impedance matching for the first and/or second antennas. Additionally, or alternatively, the feed networks described herein may provide reduced return loss compared with prior techniques. Accordingly, the antenna assembly may provide reduced return loss and/or increased isolation over a wider frequency bandwidth than prior techniques, resulting in improved performance of the antennas.

Additionally, or alternatively, the isolation network may enable the first and second antennas to be spaced closely apart with reduced current coupling compared to prior configurations. For example, prior antenna configurations may require spacing between the antennas of at least 1/4 of the wavelength (λ) of the associated communication signals for good isolation. In contrast, the antenna assembly described herein may include spacing of less than 1/4 of the wavelength between the antennas (e.g., a reduced or no "keep out zone" between the antennas).

Embodiments may enable less space in a computer system to be allocated for antennas. Accordingly, the system may be designed with a thin and/or light form factor, and/or more space may be used for other system components. Additionally, or alternatively, embodiments may enable the antenna assemblies to be used in a system with a full metal chassis. Furthermore, the techniques described herein may allow coexistence of the antenna assemblies with other system components, such as one or more speakers, communication/power ports (e.g., Universal Serial Bus (USB), etc.), and/or lights/display elements (e.g., light emitting diodes).

These and other embodiments will be further described below with respect to the example implementations shown in the figures.

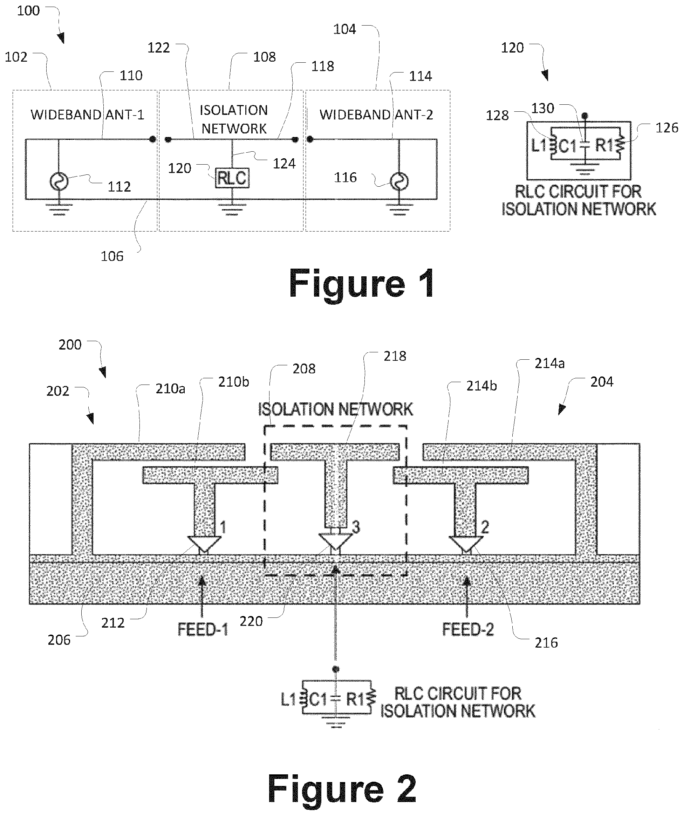

Figure 1 illustrates an antenna assembly 100 in accordance with various embodiments. The antenna assembly 100 may include a first antenna 102 and a second antenna 104 coupled to a ground plane 106. The antenna assembly 100 may further include an isolation network 108 coupled to the ground plane 106 between the first antenna 102 and the second antenna 104. The antenna 102 may include a conductive antenna portion 110 and a feed network 112 coupled between the conductive antenna portion 110 and the ground plane 106. In embodiments, the conductive antenna portion 110 may also be directly conductively coupled to the ground plane, as shown in Figure 1. For example, the conductive antenna portion 110 may be an elongate strip of conductive material, e.g., in an "L" shape or other suitable shape. Similarly, the antenna 104 may include a conductive antenna portion 114 and a feed network 116 coupled between the conductive antenna portion 114 and the ground plane 106.

In various embodiments, the isolation network 108 may include a conductive structure 118 and an isolation circuit 120. In embodiments, the conductive structure 118 may include a first portion 122 that is between the respective conductive portions 110 and 114 of the first and second antennas 102 and 104, and a second portion 124 to conductively couple the first portion 122 to the isolation circuit. The first portion may extend laterally such that a width of the first portion 122 is greater than a width of the second portion 124 (e.g., in a direction between the conductive antenna portions 110 and 114). Accordingly, the conductive structure 118 may have a "T" shape.

In some embodiments, as further shown in claim 1, the isolation circuit 120 may include a resistor 126, an inductor 128, and a capacitor 130 (e.g., also referred to as an RLC circuit). For example, the resistor 126, inductor 128, and capacitor 130 may be coupled in parallel with one another and between the conductive structure 118 and the ground plane 106. In other embodiments, the isolation circuit 120 may include additional components, fewer components, and/or a different arrangement of components. For example, some embodiments may include a capacitor and a resistor (e.g., coupled in parallel or in series with one another), and no inductor. Embodiments of the isolation circuit 120 may include any suitable values and/or configuration to provide the desired isolation performance. For example, some embodiments may implement a high-pass or band-pass filter. In some embodiments, the resistor 126 may have a value of 20 to 500 Ω, such as about 50 Ω, and/or the capacitor 130 may have a value of 1 to 20 pF, such as about 6 pF. It will be apparent that other values may be used.

In various embodiments, the isolation network 108 may improve isolation between the first antenna 102 and the second antenna 104 and/or impedance matching for the first antenna 102 and/or second antenna 104. Accordingly, the isolation network 108 may enable the first and second antennas 102 and 104 to be spaced closely apart with reduced current coupling compared to prior configurations. For example, in some embodiments, the antennas 102 and 104 may be spaced apart by less than 1/4 of the wavelength of the RF signals, such as 1/10 of the wavelength or less.

Figure 2 illustrates an antenna structure 200 that may correspond to one example of the antenna structure 100, in accordance with various embodiments. For example, the antenna structure 200 may include a first antenna 202 and a second antenna 204 coupled to a ground plane 206. The antenna 202 may include conductive antenna portions 210a and 210b. As shown, the conductive antenna portion 210a may be an "L" shape and conductive antenna portion 210b may be a "T" shape. It will be apparent that other configurations of the conductive antenna portions 210a-b may be used in other embodiments. A feed network 212 may be coupled between the conductive antenna portion 210b and the ground plane 206. The antenna 204 may include conductive antenna portions 214a-b and a feed network 216 coupled between the conductive antenna portion 214b and the ground plane 206.

An isolation network 208 may be coupled to the ground plane 206 between the antennas 202 and 204. The isolation network 208 may include a conductive structure 218 (e.g., a "T" shape conductive structure) and an isolation circuit 220 coupled between the conductive structure 218 and the ground plane 206. The isolation circuit 220 may correspond to the isolation circuit 120 shown in Figure 1. For example, the isolation circuit 220 may be an RLC circuit with a resistor, an inductor, and a capacitor coupled in parallel with one another between the conductive structure 218 and the ground plane 206.

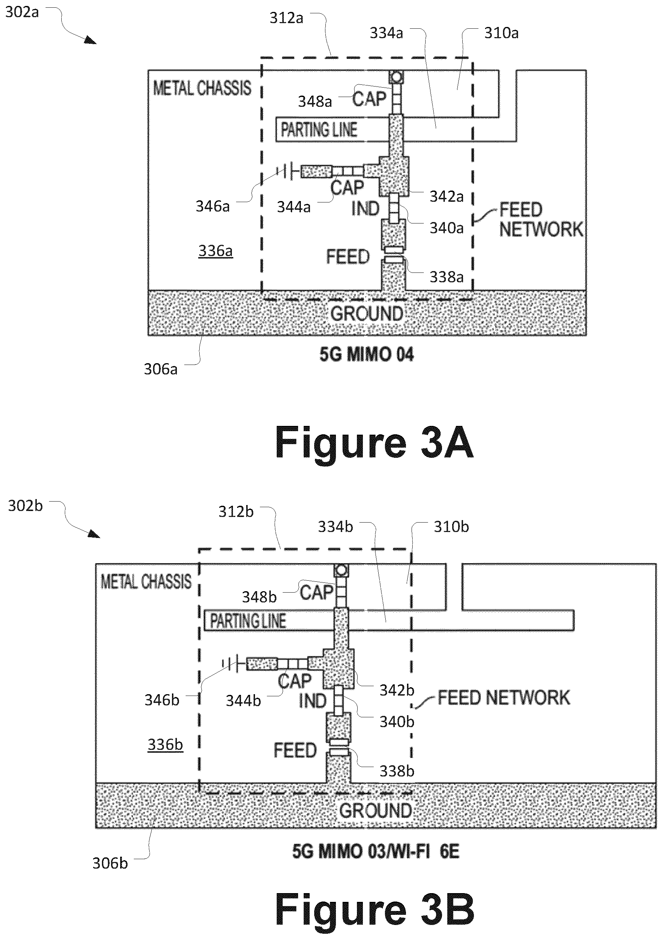

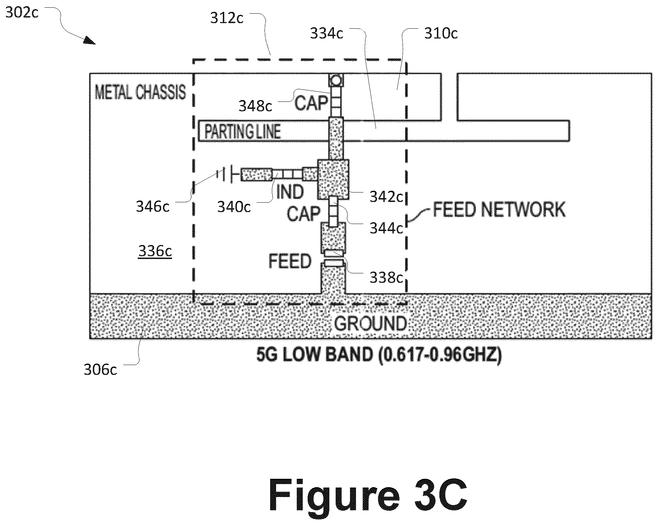

Figures 3A, 3B, and 3C illustrate antennas 302a-c that include respective examples of a feed network 312a-c in accordance with various embodiments. In embodiments, the feed network 312a-c may correspond to the feed network 112 and/or 116 discussed above. The antennas 302a-c may be designed to be used with different frequency ranges and/or wireless communication protocols. For example, the antenna 302a may be a 5G MIMO 04 antenna, the antenna 302b may be a 5G MIMO 03 and/or WiFi 6E antenna, and/or the antenna 302c may be a 5G low band antenna (e.g., used for a frequency range of 0.617-0.96 GHz and/or another suitable frequency range). The antennas 302a-c may include a conductive antenna portion 310a-c defined by a parting line 334a-c. In embodiments, the conductive antenna portion 310a-c be formed by a metal chassis. The conductive antenna portion 310a-c may be conductively coupled to a body 336a-c of the metal chassis (e.g., around the parting line 334a-c). The body 336a-c may be coupled to a ground plane 306. The ground plane 306 may correspond to chassis ground and/or PCB/FCP ground, which may be coupled to one another).

In other embodiments, the conductive antenna portion 310a-c may be formed by a PCB and/or another suitable conductive structure. For example, the conductive antenna portion 310a-c may include one or more conductive traces in the PCB. In some embodiments, the antenna 310a-c may be used with a communication device with a non-metal (e.g., plastic) chassis.

The parting line 334a-c may include a non-conductive material, such as a plastic and/or another suitable material. For example, the parting line 334a-c may be embedded in the metal chassis to separate the portions of the metal chassis on either side of the parting line 334a-c (although the portions of the metal chassis may still be coupled to one another around the parting line 334a-c as shown in Figures 3A-3C).

In various embodiments, the conductive antenna portion 310a-c and/or parting line 334a-c may have any suitable shape, e.g., based on the frequency range and/or wireless communication protocol for which the antenna 302a-c is to be used. For example, the parting line 334a may have an "L" shape, while the parting line 334b-c may have a "T" shape. It will be apparent that other shapes of the parting line and/or conductive antenna portion may be used, such as a parting line with an "F" shape or other suitable shape.

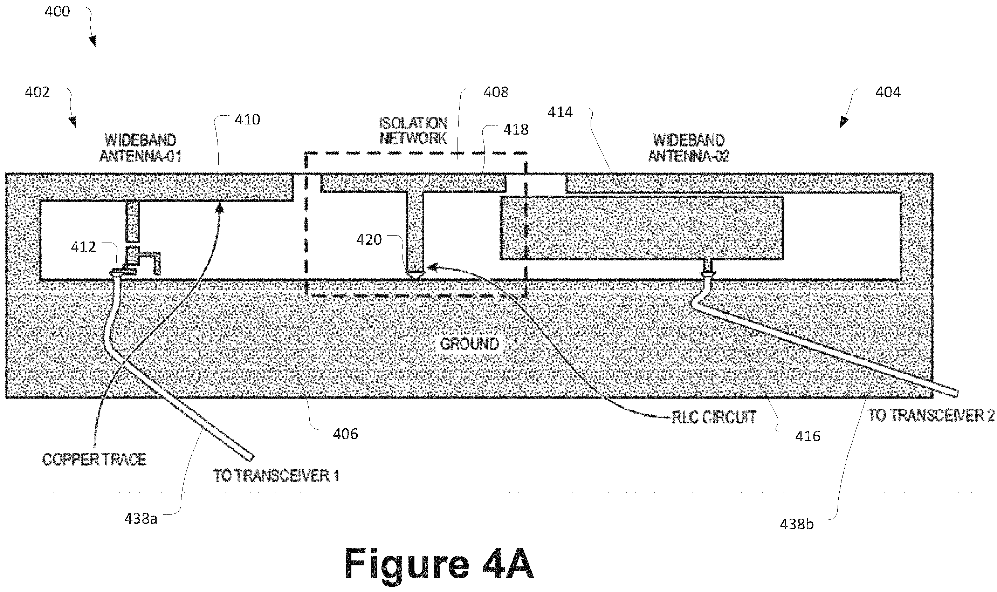

In various embodiments, the feed network 312a-c may be coupled between the conductive antenna portion 310a-c and the ground plane 306a-c. The feed network 312a-c may include a feed element 338a-c to pass an RF signal to or from the conductive antenna portion 310a-c (e.g., for transmission or reception of the RF signal). For example, the feed element 338a-c may include a conductor, such as a conductive cable as shown in Figure 4A, a conductive trace, and/or an FCP.

The feed network 312a-c may include circuit elements (e.g., one or more inductors and/or capacitors) to provide impedance matching and/or the frequency bandwidth of the antenna 302a-c. For example, as shown in Figures 3A and 3B, the feed network 312a-b may include an inductor 340a-b coupled between the feed element 338a-b and an internal node 342a-b of the feed network 312a-b. The feed network 312a-b may further include a capacitor 344a-b coupled between the internal node 342a-b and ground 346a-b (with may correspond to the ground plane 306a-b, the chassis ground, and/or a PCB/FCP ground, which in some embodiments may be coupled to one another).

In other embodiments, as shown in Figure 3C, the feed network may include a capacitor 344c coupled between a feed element 338c and an internal node 342c, and an inductor 340c coupled between the internal node 342c and ground 346c (also referred to as coupled in shunt).

The arrangement and/or values of the inductor 340a-c and capacitor 344a-c in the feed network 312a-c may determine a frequency range of operation of the corresponding antenna 302a-c. For example, the antenna 302c may be used for a lower frequency range than antennas 302a-b.

In various embodiments, the feed network 312a-c may further include a capacitor 348a-c coupled between the internal node 342a-c and the conductive antenna portion 310a-c. The capacitor 348a-c may provide protection from electrostatic discharge (ESD) and/or other functionality.

The feed network 312a-c may enhance operating frequency bandwidth and impedance matching of the antenna 302a-c. For example, the feed network 312a-c may enable the antenna 302a-c to be tuned for wideband frequency operation. In some embodiments, one or more components of the feed network 312a-c may be tunable, e.g., as discussed further elsewhere herein.

In some embodiments, the feed network 312a-c may be at least partially included on an FPC. Additionally, the feed network 312a-c may be used with different configurations/types of antennas, such as metal split/slot antennas, PCB antennas, and/or metal ring antennas. Furthermore, the feed network 312a-c may be adapted for use with different frequency ranges and/or wireless communication protocols.

Figures 4A-4D, 5-8, and 9A-9E illustrate various example implementations of antenna assemblies in accordance with various embodiments. It will be apparent that various features of the antenna assemblies described elsewhere herein, e.g., with reference to Figures 1-3, may be used in the antenna assemblies of Figures 4A-9E. For ease of understanding, the descriptions of all of the components of the antenna assemblies will not be repeated for each figure.

For example, Figure 4A illustrates an antenna assembly 400 in accordance with various embodiments. In some embodiments, the antenna assembly 400 may be implemented in a PCB and/or FCB. The antenna assembly 400 may include an isolation network 408 coupled to a ground plane 406 between antennas 402 and 404. The antenna 402 may include a conductive antenna portion 410 and a feed network 412, and the antenna 404 may include a conductive antenna portion 414 and the feed network 416. In embodiments, the conductive antenna portions 410 and 414 may have different configurations, as shown. The isolation network 408 may include a conductive structure 418 and an isolation circuit 420.

In some embodiments, the conductive antenna portion 410, conductive antenna portion 414, and/or conductive structure 418 may be included in a PCB (e.g., respectively formed by one or more conductive traces). Additionally, or alternatively, the feed network 412, feed network 416, and/or isolation circuit 420 may be implemented in a FCB and/or PCB. The feed network 412 may include a conductive cable 438a coupled to a first transceiver, and the feed network 416 may include a conductive cable 438b coupled to a second transceiver. The conductive cables 438a-b may correspond to the feed element of the respective feed network 412/416.

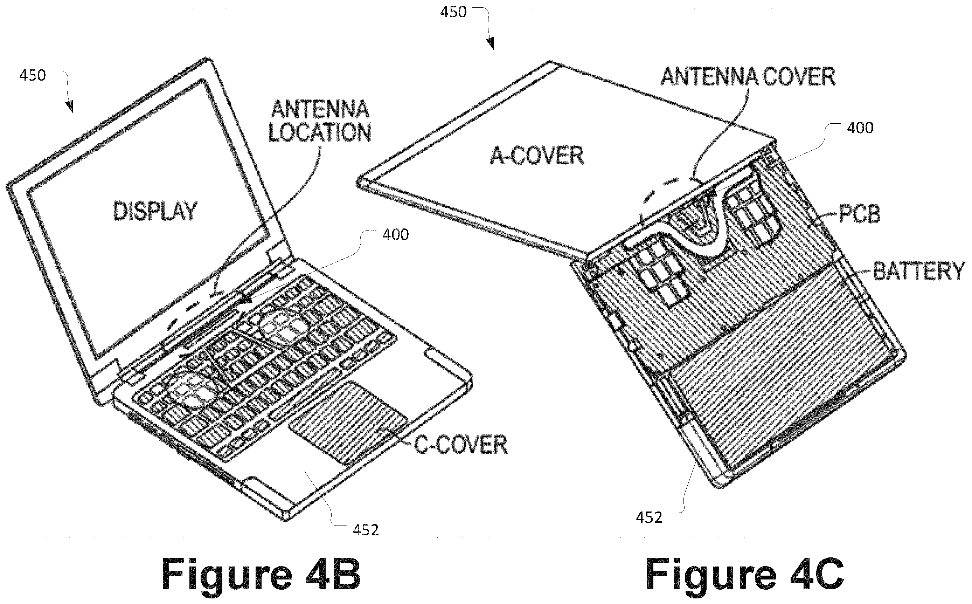

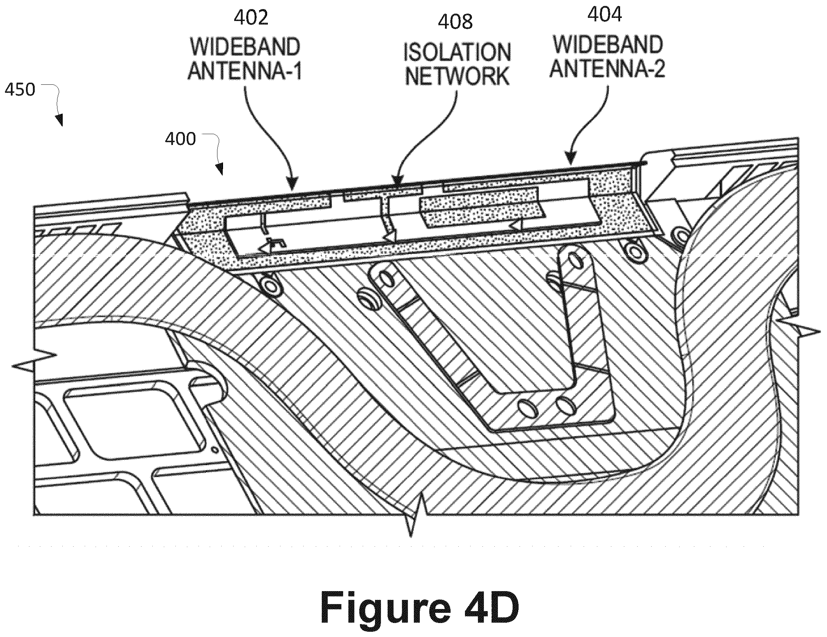

Figures 4B, 4C, and 4D illustrate the antenna assembly 400 included in a laptop computer system 450 (referred to as "laptop 450"), in accordance with various embodiments. The antenna assembly 400 may be included in the base 452 of the laptop 450, e.g., adjacent the hinge between the base and the cover/display 454. The antenna assembly 400 may be coupled to and/or included in a PCB 456 in the base 452 of the laptop 450.

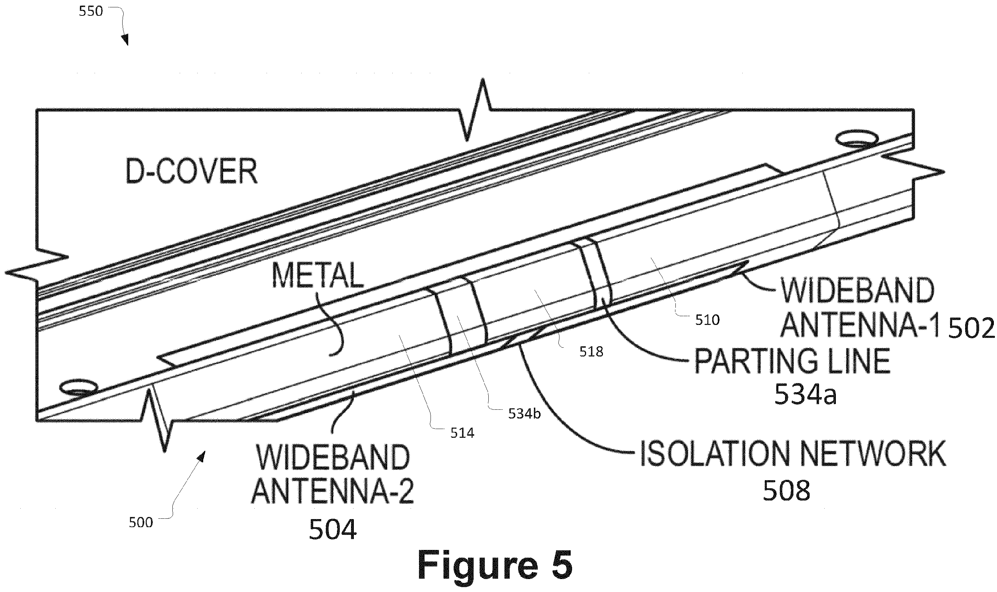

Figure 5 illustrates another implementation of an antenna assembly 500 (which may be similar to the antenna assembly 400) in a laptop 550. The antenna assembly 500 may be an aperture antenna and/or metal ring antenna. The antenna assembly 500 may be located in and/or adjacent to a back cover 556 of the base (e.g., the D-cover) of the laptop 550.

The antenna assembly 500 may include a conductive antenna portion 510 of a first antenna and a conductive antenna portion 514 of a second antenna, with a conductive structure 518 of an isolation network disposed between them. Parting lines 534a-b may be between the conductive structure 518 and the respective conductive antenna structures 510 and 514.

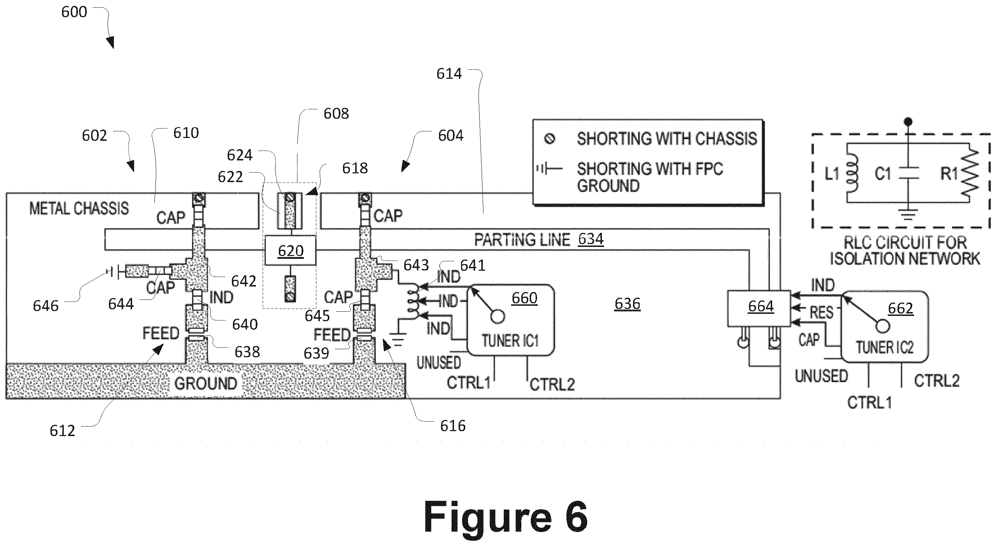

Figure 6 illustrates another antenna assembly 600 in accordance with various embodiments. Antenna assembly 600 is depicted as a metal split/slot antenna. Other embodiments may include another type of antenna. The antenna assembly 600 may be a dual feed antenna, e.g., with a first antenna 602 and a second antenna 604 with respective feed networks 612 and 616 to handle communication over different frequency bands of a same wireless communication protocol.

For example, in some embodiments, the antenna assembly 600 may be used for 5G wireless cellular communication. Implementation of a single-feed 5G antenna is a challenge in devices with a small form factor, such as mobile phones and/or tablets. Accordingly, a multifeed antenna, such as antenna assembly 600 may be used to cover the required frequency band (e.g., 0.6 GHz. - 6 GHz), with each antenna and associated feed network covering a portion of the frequency band.

In various embodiments, the feed network 612 may include an inductor 640 coupled between the feed element 638 and internal node 642, and a capacitor 644 coupled between the internal node 642 and ground 646. The feed network 616 may include a capacitor 645 coupled between the feed element 639 and an internal node 643, and an inductor 641 coupled between the internal node 643 and ground 646. Ground 646 may correspond to an FPC ground (e.g., when the feed network 612 and/or 616 are implemented in a FPC). The FPC ground may be coupled to the chassis body 636 (which may correspond to chassis ground). Ground 646 and/or chassis body 636 may correspond to the ground plane.

In various embodiments, the antenna assembly 600 may further include a first tuner circuit 660 and/or a second tuner circuit 662 coupled to the second antenna 604. The first tuner circuit 660 may be coupled to the inductor 641 of the feed network 616 to control an inductance of the inductor 641. An impedance matching circuit 664 may be coupled across the parting line 635 of the second antenna 604 (e.g., between conductive antenna portion 614 and chassis body 636) The second tuner circuit 662 may be coupled to the impedance matching circuit 664 to control a mode of the impedance matching circuit 664. For example, the mode may correspond to an impedance characteristic, such as inductive, resistive, and/or capacitive.

In embodiments, the first tuner circuit 660 and/or second tuner circuit 662 may receive one or more control signals (e.g., ctrl1 and ctrl2) to control a state of the second antenna 604. For example, Table 1 illustrates an example frequency band distribution for the antenna assembly 600. In the example, the first antenna 602 may cover the mid-band (e.g., 1.7-2.7 GHz) and a portion of the high band (e.g., 3.3-4.2 GHz) of 5G. The second antenna 604 may cover the low band (e.g., 0.617-0.96 GHz) and a portion of the high band (e.g., 4.4-6 GHz). The first tuner circuit 660 and second tuner circuit 662 may be used to cover the low band (e.g., 0.617-0.96 GHz) using three states, as shown. The second antenna 604 may cover different frequency ranges in the low band depending on the state. The frequency ranges may overlap with one another.

**Table 1: Dual feed 5G antenna frequency band distribution**

| **Second Antenna** | | | | | | **First Antenna** |
|---|---|---|---|---|---|---|
| **Low Band** | | | | | **High Band (MHz)** | **Mid Band + High Band (MHz)** |
| **States** | -4dB Frequency Band (MHz) | Ctrl 1, Ctrl 2 | Tuner IC 1 | Tuner IC 2 | 4400-6000 | 1700-2700 |
| **State 1** | 617-764 | 0,0 | IND (34nH) | IND (4.4nH) | | |
| **State 2** | 700-896 | 0,1 | IND (25nH) | RES (0 Ohm) | | 3300-4200 |
| **State 3** | 820-960 | 1,0 | IND (19nH) | CAP (9.8pF) | | |
| **State 4** | Unused | | | | | |

For example, in a first state, the inductor 641 may have an inductance of 34 nanoHenry (nH), the matching circuit 664 may present an inductance of 4.4 nH, and the second antenna 604 may cover a frequency band of 617-764 MHz. In a second state, the inductor 641 may have an inductance of 25 nH, the impedance matching circuit may present a resistance of 0 Ohm (e.g., a short circuit), and the second antenna 604 may cover a frequency band of 700-896 MHz. In a third state, the inductor 641 may have an inductance of 19 nH, the matching circuit 664 may present a capacitance of 9.8 picoFarads (pF), and the second antenna 604 may cover a frequency band of 820-960 MHz.

In various embodiments, the antenna assembly 600 may further include an isolation network 608 coupled to the chassis body 636 (e.g., chassis ground, which may correspond to the ground plane) between the first antenna 602 and the second antenna 604. The isolation network 608 may include a conductive structure 618 between conductive antenna portions 610 and 614, and an isolation circuit 620 (e.g., RLC circuit) coupled between the conductive structure 618 and the chassis body 636. In embodiments, the conductive structure 618 may include a first conductive portion 622 that is implemented by the chassis and a second conductive portion 624 that is implemented by the FCP that includes the isolation circuit 620. The first conductive portion 622 may be wider than the second conductive portion 624, e.g., to form a "T" shape as discussed herein.

In various embodiments, the isolation network 608 may improve isolation between the first antenna 602 and the second antenna 604. The improved isolation may facilitate operation of the tuner circuits 660 and/or 662, so that controlling the low frequency bandwidth using the tuner circuits 660 and/or 662 does not affect the response of the feed network 612 of the other antenna 602. The isolation network 608 may additionally or alternatively improve impedance matching of the first antenna 602 and/or second antenna 604. Accordingly, the isolation network 608 may provide improved return loss characteristics compared with antenna assemblies that do not include an isolation network.

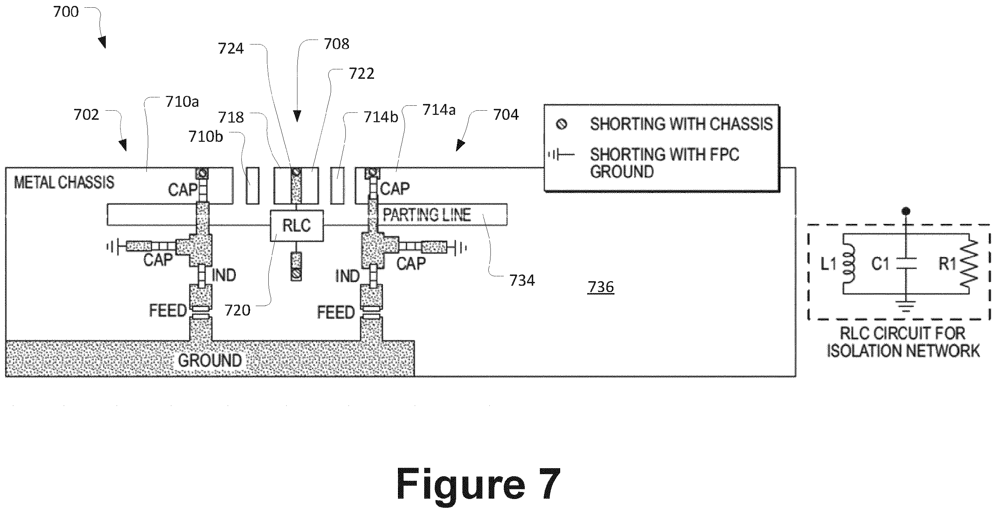

Figure 7 illustrates another antenna assembly 700 in accordance with various embodiments. The antenna assembly 700 may be a combo F-shaped metal split (slot) antenna. For example, the antenna assembly 700 may include a first antenna 702 and a second antenna 704 with an F-shaped parting line 734. Accordingly, the first antenna 702 may include conductive antenna portions 710a-b, and the second antenna 704 may include conductive antenna portions 714a-b. In some embodiments, the antenna assembly 700 may be used as a 5G-MIMO combo antenna.

In various embodiments, the antenna assembly 700 may further include an isolation network 708 coupled to the chassis body 736 (e.g., chassis ground, which may correspond to the ground plane) between the first antenna 702 and the second antenna 704. The isolation network 708 may include a conductive structure 718 between conductive antenna portions 710a-b and 714a-b, and an isolation circuit 720 (e.g., RLC circuit) coupled between the conductive structure 718 and the chassis body 736. In embodiments, the conductive structure 718 may include a first conductive portion 722 that is implemented by the chassis and a second conductive portion 724 that is implemented by the FCP that includes the isolation circuit 720. The first conductive portion 722 may be wider than the second conductive portion 724, e.g., to form a "T" shape as discussed herein.

In various embodiments, the isolation network 708 may improve the isolation and/or impedance matching for antennas 702 and/or 704.

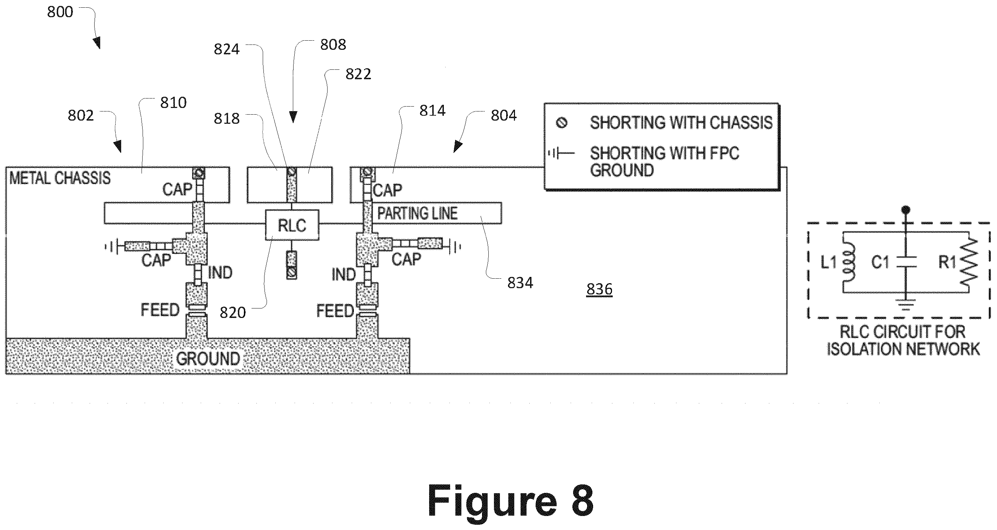

Figure 8 illustrates another antenna assembly 800 in accordance with various embodiments. The antenna assembly 800 may be a combo L-shaped metal split (slot) antenna. For example, the antenna assembly 800 may include a first antenna 802 and a second antenna 804 with an L-shaped parting line 834. Accordingly, the first antenna 802 may include a conductive antenna portions 810, and the second antenna 804 may include a conductive antenna portion 814.

In various embodiments, the antenna assembly 800 may further include an isolation network 808 coupled to the chassis body 836 (e.g., chassis ground, which may correspond to the ground plane) between the first antenna 802 and the second antenna 804. The isolation network 808 may include a conductive structure 818 between conductive antenna portions 810 and 814, and an isolation circuit 820 (e.g., RLC circuit) coupled between the conductive structure 818 and the chassis body 836. In embodiments, the conductive structure 818 may include a first conductive portion 822 that is implemented by the chassis and a second conductive portion 824 that is implemented by the FCP that includes the isolation circuit 820. The first conductive portion 822 may be wider than the second conductive portion 824, e.g., to form a "T" shape as discussed herein.

In various embodiments, the isolation network 808 may improve the isolation and/or impedance matching for antennas 802 and/or 804.

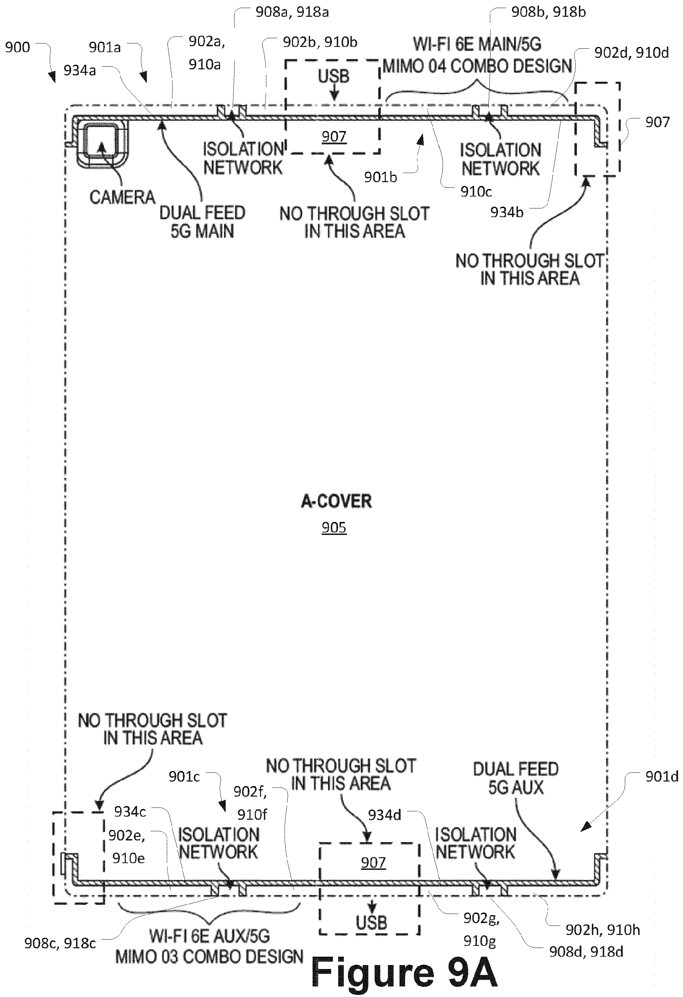

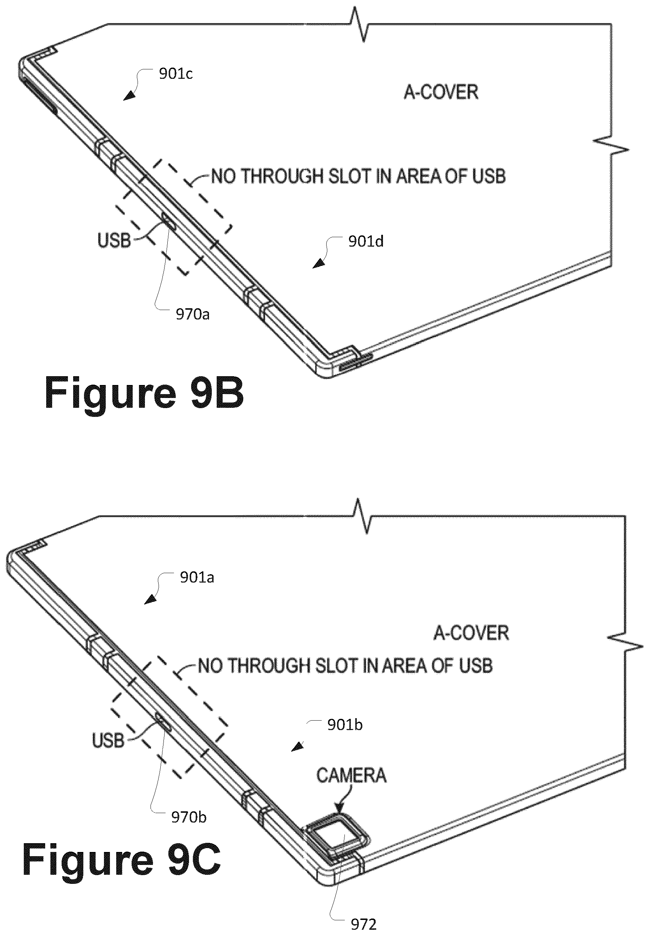

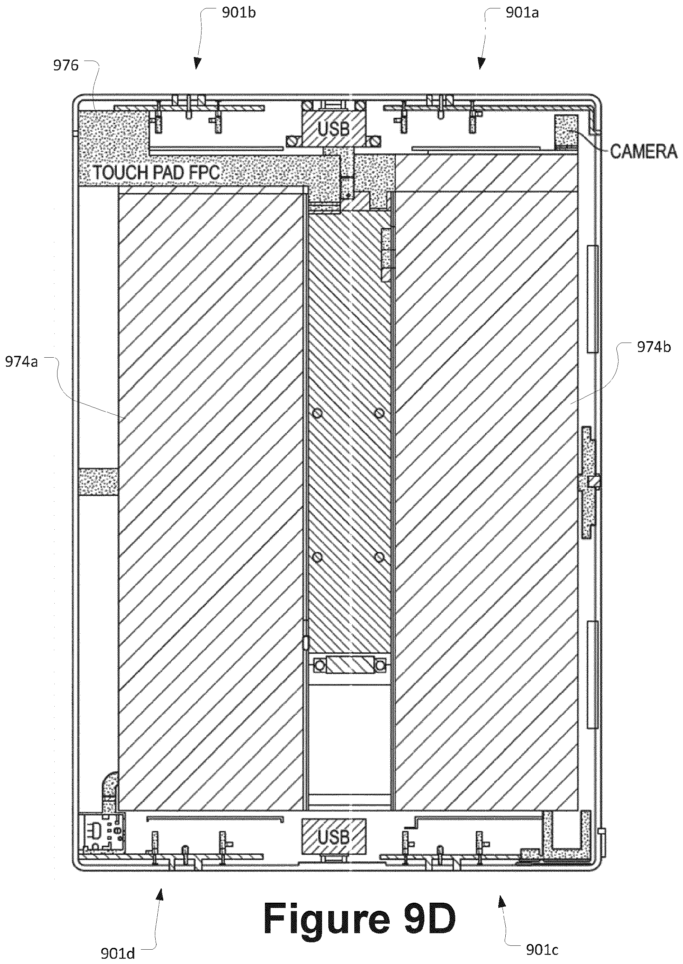

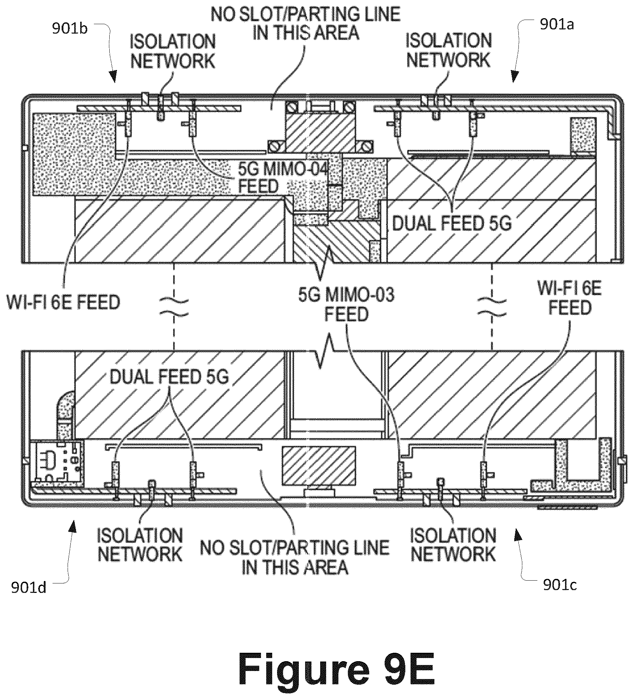

Figures 9A-9E illustrate an example tablet computing device 900 (referred to as "tablet 900") in accordance with various embodiments. For example, Figure 9A is a top view from a rear cover (A-cover) side of the tablet 900. Figures 9B and 9C are perspective views of respective ends of the tablet 900 from the rear cover side. Figure 9D is a top view from the display side of the tablet 900, showing internal components of the tablet 900. Figure 9E shows close-up views of end regions of the view shown in Figure 9D.

The computing device 900 may include a plurality of antenna assemblies 901a-d, and each antenna assembly 901a-d may include one or more antennas 904a-h. For instance, in the example implementation shown in Figure 9, the tablet 900 includes four antenna assemblies 901a-d that each include two antennas 902a-h.

The antennas 902a-h may be at least partially implemented in a metal chassis 905 of the tablet 900, e.g., as metal split antennas. For example, the antennas 902a-h may include respective conductive antenna portions 910a-h that are implemented by the chassis 905. The antenna assemblies 901a-d may further include respective isolation networks 908a-d. The isolation networks 908a-d may include respective conductive structures 918a-d between the conductive antenna portions 910a-h of the respective antenna assemblies 901a-d.

In various embodiments, the antenna assemblies 901a-d may include respective parting lines 934a-d in the metal chassis 905 to form the conductive antenna portions 910a-h and/or conductive structures 918a-d. The parting lines 934a-d may be a slot in the metal chassis 905, which may include a plastic or other non-conductive material. In some embodiments, from the rear cover side of the tablet 900 (e.g., as shown in Figures 9A-9C), it may appear that the parting lines 934a-d continue between different antenna assemblies 901a-d. However, as shown in Figures 9D and 9E, the parting line 934a-d (e.g., slot) may not extend all the way through the chassis 905 in one or more regions 907. In some embodiments, another component of the tablet 900, such as a communication and/or power interface (e.g., a Universal Serial Bus^{®} (USB) port 970a-b, a Thunderbolt^{®} port, and/or another suitable port), a camera 972, a memory card reader, and/or another component may be in one or more of the regions 907. The absence of the parting line 934a-d through the chassis 905 in the regions 907 may prevent performance degradation for the other component(s).

In various embodiments, the tablet 900 may include antenna assemblies 901a-d with any suitable combination of configurations. For example, as shown in Figures 9A-9E, the antenna assembly 901a may be a main dual feed 5G antenna assembly; antenna assembly 901b may be a WiFi 6E main/5G MIMO 04 combo antenna assembly; antenna assembly 901c may be a WiFi 6E auxiliary/5G MIMO 03 combo antenna assembly; and antenna assembly 901d may be an auxiliary dual feed 5G antenna. It will be apparent that other combinations of antenna assemblies 901a-d and/or antennas 902a-h may be used in other implementations.

The tablet 900 may any suitable combination of additional components, such as batteries 974a-b and/or touch pad FPC 976 (for a touch pad display, not shown), as best seen in Figure 9D.

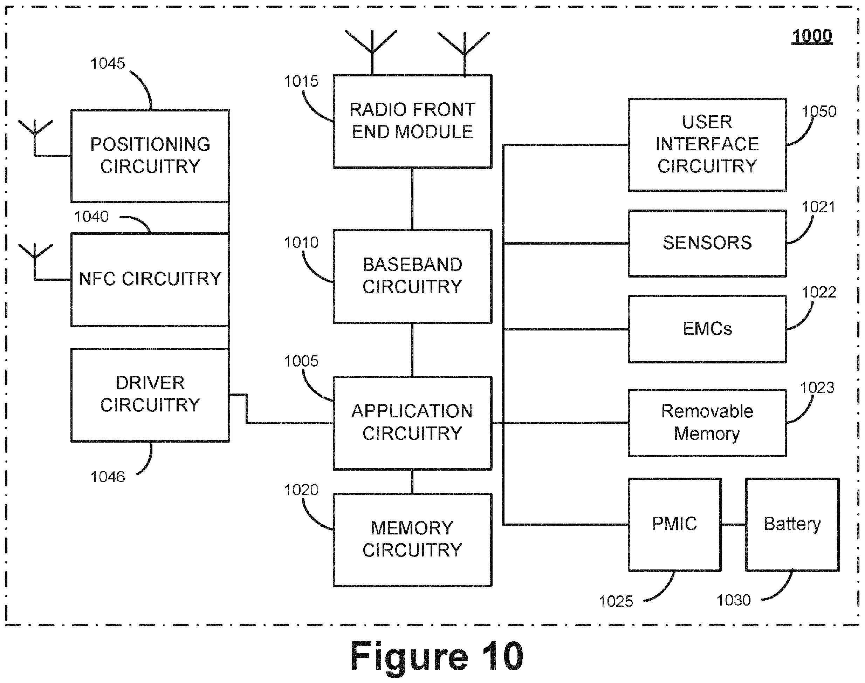

Figure 10 illustrates an example of a platform 1000 (or "device 1000") in accordance with various embodiments. The platform 1000 may include one or more antenna assemblies as discussed herein. For example, the platform 1000 may correspond to the laptop computer 450 of Figures 4B-4D, the laptop computer 550 of Figure 5, the tablet 900 of Figure 9, and/or another suitable computing device capable of communicating over one or more wireless communication protocols.

The platform 1000 may include any combinations of the components shown in the example. The components of platform 1000 may be implemented as integrated circuits (ICs), portions thereof, discrete electronic devices, or other modules, logic, hardware, software, firmware, or a combination thereof adapted in the computer platform 1000, or as components otherwise incorporated within a chassis of a larger system. The block diagram of Figure 10 is intended to show a high level view of components of the computer platform 1000. However, some of the components shown may be omitted, additional components may be present, and different arrangement of the components shown may occur in other implementations.

Application circuitry 1005 includes circuitry such as, but not limited to one or more processors (or processor cores), cache memory, and one or more of LDOs, interrupt controllers, serial interfaces such as SPI, I2C or universal programmable serial interface module, RTC, timer-counters including interval and watchdog timers, general purpose I/O, memory card controllers such as SD MMC or similar, USB interfaces, MIPI interfaces, and JTAG test access ports. The processors (or cores) of the application circuitry 1005 may be coupled with or may include memory/storage elements and may be configured to execute instructions stored in the memory/storage to enable various applications or operating systems to run on the system 1000. In some implementations, the memory/storage elements may be on-chip memory circuitry, which may include any suitable volatile and/or non-volatile memory, such as DRAM, SRAM, EPROM, EEPROM, Flash memory, solid-state memory, and/or any other type of memory device technology, such as those discussed herein.

The processor(s) of application circuitry 1005 may include, for example, one or more processor cores, one or more application processors, one or more GPUs, one or more RISC processors, one or more ARM processors, one or more CISC processors, one or more DSP, one or more FPGAs, one or more PLDs, one or more ASICs, one or more microprocessors or controllers, a multithreaded processor, an ultra-low voltage processor, an embedded processor, some other known processing element, or any suitable combination thereof. In some embodiments, the application circuitry 1005 may comprise, or may be, a special-purpose processor/controller to operate according to the various embodiments herein.

As examples, the processor(s) of application circuitry 1005 may include an Intel^{®} Architecture Core^{™} based processor, such as a Quark^{™}, an Atom^{™}, an i3, an i5, an i7, or an MCU-class processor, or another such processor available from Intel^{®} Corporation, Santa Clara, CA. The processors of the application circuitry 1005 may also be one or more of Advanced Micro Devices (AMD) Ryzen^{®} processor(s) or Accelerated Processing Units (APUs); A5-A9 processor(s) from Apple^{®} Inc., Snapdragon^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; or the like. In some implementations, the application circuitry 1005 may be a part of a system on a chip (SoC) in which the application circuitry 1005 and other components are formed into a single integrated circuit, or a single package, such as the Edison^{™} or Galileo^{™} SoC boards from Intel^{®} Corporation.

Additionally or alternatively, application circuitry 1005 may include circuitry such as, but not limited to, one or more a field-programmable devices (FPDs) such as FPGAs and the like; programmable logic devices (PLDs) such as complex PLDs (CPLDs), high-capacity PLDs (HCPLDs), and the like; ASICs such as structured ASICs and the like; programmable SoCs (PSoCs); and the like. In such embodiments, the circuitry of application circuitry 1005 may comprise logic blocks or logic fabric, and other interconnected resources that may be programmed to perform various functions, such as the procedures, methods, functions, etc. of the various embodiments discussed herein. In such embodiments, the circuitry of application circuitry 1005 may include memory cells (e.g., erasable programmable read-only memory (EPROM), electrically erasable programmable read-only memory (EEPROM), flash memory, static memory (e.g., static random access memory (SRAM), anti-fuses, etc.)) used to store logic blocks, logic fabric, data, etc. in look-up tables (LUTs) and the like.

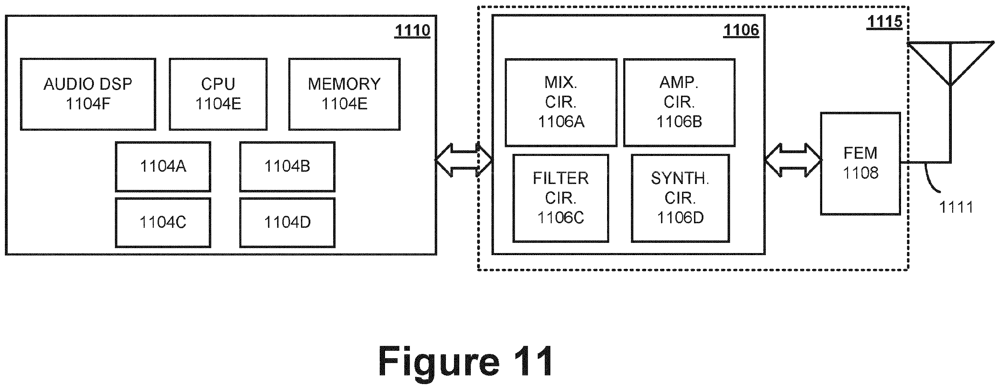

The baseband circuitry 1010 may be implemented, for example, as a solder-down substrate including one or more integrated circuits, a single packaged integrated circuit soldered to a main circuit board or a multi-chip module containing two or more integrated circuits. The various hardware electronic elements of baseband circuitry 1010 are discussed infra with regard to Figure 11.

The RFEMs 1015 may comprise a millimeter wave (mmWave) RFEM and one or more sub-mmWave radio frequency integrated circuits (RFICs). In some implementations, the one or more sub-mmWave RFICs may be physically separated from the mm Wave RFEM. The RFICs may include connections to one or more antennas or antenna arrays (see e.g., antenna array 1111 of Figure 11 infra), and the RFEM may be connected to multiple antennas. In alternative implementations, both mmWave and sub-mmWave radio functions may be implemented in the same physical RFEM 1015, which incorporates both mmWave antennas and sub-mmWave.

The memory circuitry 1020 may include any number and type of memory devices used to provide for a given amount of system memory. As examples, the memory circuitry 1020 may include one or more of volatile memory including random access memory (RAM), dynamic RAM (DRAM) and/or synchronous dynamic RAM (SDRAM), and nonvolatile memory (NVM) including high-speed electrically erasable memory (commonly referred to as Flash memory), phase change random access memory (PRAM), magnetoresistive random access memory (MRAM), etc. The memory circuitry 1020 may be developed in accordance with a Joint Electron Devices Engineering Council (JEDEC) low power double data rate (LPDDR)-based design, such as LPDDR2, LPDDR3, LPDDR4, or the like. Memory circuitry 1020 may be implemented as one or more of solder down packaged integrated circuits, single die package (SDP), dual die package (DDP) or quad die package (Q17P), socketed memory modules, dual inline memory modules (DIMMs) including microDIMMs or MiniDIMMs, and/or soldered onto a motherboard via a ball grid array (BGA). In low power implementations, the memory circuitry 1020 may be on-die memory or registers associated with the application circuitry 1005. To provide for persistent storage of information such as data, applications, operating systems and so forth, memory circuitry 1020 may include one or more mass storage devices, which may include, inter alia, a solid state disk drive (SSDD), hard disk drive (HDD), a micro HDD, resistance change memories, phase change memories, holographic memories, or chemical memories, among others. For example, the computer platform 1000 may incorporate the three-dimensional (3D) crosspoint (XPOINT) memories from Intel^{®} and Micron^{®}.

Removable memory circuitry 1023 may include devices, circuitry, enclosures/housings, ports or receptacles, etc. used to couple portable data storage devices with the platform 1000. These portable data storage devices may be used for mass storage purposes, and may include, for example, flash memory cards (e.g., Secure Digital (SD) cards, microSD cards, xD picture cards, and the like), and USB flash drives, optical discs, external HDDs, and the like.

The platform 1000 may also include interface circuitry (not shown) that is used to connect external devices with the platform 1000. The external devices connected to the platform 1000 via the interface circuitry include sensor circuitry 1021 and electro-mechanical components (EMCs) 1022, as well as removable memory devices coupled to removable memory circuitry 1023.

The sensor circuitry 1021 include devices, modules, or subsystems whose purpose is to detect events or changes in its environment and send the information (sensor data) about the detected events to some other a device, module, subsystem, etc. Examples of such sensors include, inter alia, inertia measurement units (IMUs) comprising accelerometers, gyroscopes, and/or magnetometers; microelectromechanical systems (MEMS) or nanoelectromechanical systems (NEMS) comprising 3-axis accelerometers, 3-axis gyroscopes, and/or magnetometers; level sensors; flow sensors; temperature sensors (e.g., thermistors); pressure sensors; barometric pressure sensors; gravimeters; altimeters; image capture devices (e.g., cameras or lensless apertures); light detection and ranging (LiDAR) sensors; proximity sensors (e.g., infrared radiation detector and the like), depth sensors, ambient light sensors, ultrasonic transceivers; microphones or other like audio capture devices; etc.

EMCs 1022 include devices, modules, or subsystems whose purpose is to enable platform 1000 to change its state, position, and/or orientation, or move or control a mechanism or (sub)system. Additionally, EMCs 1022 may be configured to generate and send messages/signalling to other components of the platform 1000 to indicate a current state of the EMCs 1022. Examples of the EMCs 1022 include one or more power switches, relays including electromechanical relays (EMRs) and/or solid state relays (SSRs), actuators (e.g., valve actuators, etc.), an audible sound generator, a visual warning device, motors (e.g., DC motors, stepper motors, etc.), wheels, thrusters, propellers, claws, clamps, hooks, and/or other like electro-mechanical components. In embodiments, platform 1000 is configured to operate one or more EMCs 1022 based on one or more captured events and/or instructions or control signals received from a service provider and/or various clients.

In some implementations, the interface circuitry may connect the platform 1000 with positioning circuitry 1045. The positioning circuitry 1045 includes circuitry to receive and decode signals transmitted/broadcasted by a positioning network of a GNSS. Examples of navigation satellite constellations (or GNSS) include United States' GPS, Russia's GLONASS, the European Union's Galileo system, China's BeiDou Navigation Satellite System, a regional navigation system or GNSS augmentation system (e.g., NAVIC), Japan's QZSS, France's DORIS, etc.), or the like. The positioning circuitry 1045 comprises various hardware elements (e.g., including hardware devices such as switches, filters, amplifiers, antenna elements, and the like to facilitate OTA communications) to communicate with components of a positioning network, such as navigation satellite constellation nodes. In some embodiments, the positioning circuitry 1045 may include a Micro-PNT IC that uses a master timing clock to perform position tracking/estimation without GNSS assistance. The positioning circuitry 1045 may also be part of, or interact with, the baseband circuitry 1010 and/or RFEMs 1015 to communicate with the nodes and components of the positioning network. The positioning circuitry 1045 may also provide position data and/or time data to the application circuitry 1005, which may use the data to synchronize operations with various infrastructure (e.g., radio base stations), for turn-by-turn navigation applications, or the like

In some implementations, the interface circuitry may connect the platform 1000 with Near-Field Communication (NFC) circuitry 1040. NFC circuitry 1040 is configured to provide contactless, short-range communications based on radio frequency identification (RFID) standards, wherein magnetic field induction is used to enable communication between NFC circuitry 1040 and NFC-enabled devices external to the platform 1000 (e.g., an "NFC touchpoint"). NFC circuitry 1040 comprises an NFC controller coupled with an antenna element and a processor coupled with the NFC controller. The NFC controller may be a chip/IC providing NFC functionalities to the NFC circuitry 1040 by executing NFC controller firmware and an NFC stack. The NFC stack may be executed by the processor to control the NFC controller, and the NFC controller firmware may be executed by the NFC controller to control the antenna element to emit short-range RF signals. The RF signals may power a passive NFC tag (e.g., a microchip embedded in a sticker or wristband) to transmit stored data to the NFC circuitry 1040, or initiate data transfer between the NFC circuitry 1040 and another active NFC device (e.g., a smartphone or an NFC-enabled POS terminal) that is proximate to the platform 1000.

The driver circuitry 1046 may include software and hardware elements that operate to control particular devices that are embedded in the platform 1000, attached to the platform 1000, or otherwise communicatively coupled with the platform 1000. The driver circuitry 1046 may include individual drivers allowing other components of the platform 1000 to interact with or control various input/output (I/O) devices that may be present within, or connected to, the platform 1000. For example, driver circuitry 1046 may include a display driver to control and allow access to a display device, a touchscreen driver to control and allow access to a touchscreen interface of the platform 1000, sensor drivers to obtain sensor readings of sensor circuitry 1021 and control and allow access to sensor circuitry 1021, EMC drivers to obtain actuator positions of the EMCs 1022 and/or control and allow access to the EMCs 1022, a camera driver to control and allow access to an embedded image capture device, audio drivers to control and allow access to one or more audio devices.

The power management integrated circuitry (PMIC) 1025 (also referred to as "power management circuitry 1025") may manage power provided to various components of the platform 1000. In particular, with respect to the baseband circuitry 1010, the PMIC 1025 may control power-source selection, voltage scaling, battery charging, or DC-to-DC conversion. The PMIC 1025 may often be included when the platform 1000 is capable of being powered by a battery 1030.

In some embodiments, the PMIC 1025 may control, or otherwise be part of, various power saving mechanisms of the platform 1000. For example, if the platform 1000 is in an RRC_Connected state, where it is still connected to the RAN node as it expects to receive traffic shortly, then it may enter a state known as Discontinuous Reception Mode (DRX) after a period of inactivity. During this state, the platform 1000 may power down for brief intervals of time and thus save power. If there is no data traffic activity for an extended period of time, then the platform 1000 may transition off to an RRC_Idle state, where it disconnects from the network and does not perform operations such as channel quality feedback, handover, etc. The platform 1000 goes into a very low power state and it performs paging where again it periodically wakes up to listen to the network and then powers down again. The platform 1000 may not receive data in this state; in order to receive data, it must transition back to RRC_Connected state. An additional power saving mode may allow a device to be unavailable to the network for periods longer than a paging interval (ranging from seconds to a few hours). During this time, the device is totally unreachable to the network and may power down completely. Any data sent during this time incurs a large delay and it is assumed the delay is acceptable.

A battery 1030 may power the platform 1000, although in some examples the platform 1000 may be mounted deployed in a fixed location, and may have a power supply coupled to an electrical grid. The battery 1030 may be a lithium ion battery, a metal-air battery, such as a zinc-air battery, an aluminum-air battery, a lithium-air battery, and the like. In some implementations, such as in V2X applications, the battery 1030 may be a typical lead-acid automotive battery.

In some implementations, the battery 1030 may be a "smart battery," which includes or is coupled with a Battery Management System (BMS) or battery monitoring integrated circuitry. The BMS may be included in the platform 1000 to track the state of charge (SoCh) of the battery 1030. The BMS may be used to monitor other parameters of the battery 1030 to provide failure predictions, such as the state of health (SoH) and the state of function (SoF) of the battery 1030. The BMS may communicate the information of the battery 1030 to the application circuitry 1005 or other components of the platform 1000. The BMS may also include an analog-to-digital (ADC) convertor that allows the application circuitry 1005 to directly monitor the voltage of the battery 1030 or the current flow from the battery 1030. The battery parameters may be used to determine actions that the platform 1000 may perform, such as transmission frequency, network operation, sensing frequency, and the like.

A power block, or other power supply coupled to an electrical grid may be coupled with the BMS to charge the battery 1030. In some examples, the power block 1030 may be replaced with a wireless power receiver to obtain the power wirelessly, for example, through a loop antenna in the computer platform 1000. In these examples, a wireless battery charging circuit may be included in the BMS. The specific charging circuits chosen may depend on the size of the battery 1030, and thus, the current required. The charging may be performed using the Airfuel standard promulgated by the Airfuel Alliance, the Qi wireless charging standard promulgated by the Wireless Power Consortium, or the Rezence charging standard promulgated by the Alliance for Wireless Power, among others.

User interface circuitry 1050 includes various input/output (I/O) devices present within, or connected to, the platform 1000, and includes one or more user interfaces designed to enable user interaction with the platform 1000 and/or peripheral component interfaces designed to enable peripheral component interaction with the platform 1000. The user interface circuitry 1050 includes input device circuitry and output device circuitry. Input device circuitry includes any physical or virtual means for accepting an input including, inter alia, one or more physical or virtual buttons (e.g., a reset button), a physical keyboard, keypad, mouse, touchpad, touchscreen, microphones, scanner, headset, and/or the like. The output device circuitry includes any physical or virtual means for showing information or otherwise conveying information, such as sensor readings, actuator position(s), or other like information. Output device circuitry may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Chrystal Displays (LCD), LED displays, quantum dot displays, projectors, etc.), with the output of characters, graphics, multimedia objects, and the like being generated or produced from the operation of the platform 1000. The output device circuitry may also include speakers or other audio emitting devices, printer(s), and/or the like. In some embodiments, the sensor circuitry 1021 may be used as the input device circuitry (e.g., an image capture device, motion capture device, or the like) and one or more EMCs may be used as the output device circuitry (e.g., an actuator to provide haptic feedback or the like). In another example, NFC circuitry comprising an NFC controller coupled with an antenna element and a processing device may be included to read electronic tags and/or connect with another NFC-enabled device. Peripheral component interfaces may include, but are not limited to, a non-volatile memory port, a USB port, an audio jack, a power supply interface, etc.

Although not shown, the components of platform 1000 may communicate with one another using a suitable bus or interconnect (IX) technology, which may include any number of technologies, including ISA, EISA, PCI, PCIx, PCIe, a Time-Trigger Protocol (TTP) system, a FlexRay system, or any number of other technologies. The bus/IX may be a proprietary bus/IX, for example, used in a SoC based system. Other bus/IX systems may be included, such as an I2C interface, an SPI interface, point-to-point interfaces, and a power bus, among others.

Figure 11 illustrates example components of baseband circuitry 1110 and radio front end modules (RFEM) 1115 in accordance with various embodiments. The baseband circuitry 1110 corresponds to the baseband circuitry 1010 of Figure 10. The RFEM 1115 corresponds to the RFEM 1015 of Figure 10. As shown, the RFEMs 1115 may include Radio Frequency (RF) circuitry 1106, front-end module (FEM) circuitry 1108, antenna array 1111 coupled together at least as shown.

The baseband circuitry 1110 includes circuitry and/or control logic configured to carry out various radio/network protocol and radio control functions that enable communication with one or more radio networks via the RF circuitry 1106. The radio control functions may include, but are not limited to, signal modulation/demodulation, encoding/decoding, radio frequency shifting, etc. In some embodiments, modulation/demodulation circuitry of the baseband circuitry 1110 may include Fast-Fourier Transform (FFT), precoding, or constellation mapping/demapping functionality. In some embodiments, encoding/decoding circuitry of the baseband circuitry 1110 may include convolution, tail-biting convolution, turbo, Viterbi, or Low Density Parity Check (LDPC) encoder/decoder functionality. Embodiments of modulation/demodulation and encoder/decoder functionality are not limited to these examples and may include other suitable functionality in other embodiments. The baseband circuitry 1110 is configured to process baseband signals received from a receive signal path of the RF circuitry 1106 and to generate baseband signals for a transmit signal path of the RF circuitry 1106. The baseband circuitry 1110 is configured to interface with application circuitry 1005 (see Figure 10) for generation and processing of the baseband signals and for controlling operations of the RF circuitry 1106. The baseband circuitry 1110 may handle various radio control functions.

The aforementioned circuitry and/or control logic of the baseband circuitry 1110 may include one or more single or multi-core processors. For example, the one or more processors may include a 3G baseband processor 1104A, a 4G/LTE baseband processor 1104B, a 5G/NR baseband processor 1104C, or some other baseband processor(s) 1104D for other existing generations, generations in development or to be developed in the future (e.g., sixth generation (6G), etc.). In other embodiments, some or all of the functionality of baseband processors 1104A-D may be included in modules stored in the memory 1104G and executed via a Central Processing Unit (CPU) 1104E. In other embodiments, some or all of the functionality of baseband processors 1104A-D may be provided as hardware accelerators (e.g., FPGAs, ASICs, etc.) loaded with the appropriate bit streams or logic blocks stored in respective memory cells. In various embodiments, the memory 1104G may store program code of a real-time OS (RTOS), which when executed by the CPU 1104E (or other baseband processor), is to cause the CPU 1104E (or other baseband processor) to manage resources of the baseband circuitry 1110, schedule tasks, etc. Examples of the RTOS may include Operating System Embedded (OSE)^{™} provided by Enea^{®}, Nucleus RTOS^{™} provided by Mentor Graphics^{®}, Versatile Real-Time Executive (VRTX) provided by Mentor Graphics^{®}, ThreadX^{™} provided by Express Logic^{®}, FreeRTOS, REX OS provided by Qualcomm^{®}, OKL4 provided by Open Kernel (OK) Labs^{®}, or any other suitable RTOS, such as those discussed herein. In addition, the baseband circuitry 1110 includes one or more audio digital signal processor(s) (DSP) 1104F. The audio DSP(s) 1104F include elements for compression/decompression and echo cancellation and may include other suitable processing elements in other embodiments.

In some embodiments, each of the processors 1104A-1104E include respective memory interfaces to send/receive data to/from the memory 1104G. The baseband circuitry 1110 may further include one or more interfaces to communicatively couple to other circuitries/devices, such as an interface to send/receive data to/from memory external to the baseband circuitry 1110; an application circuitry interface to send/receive data to/from the application circuitry 1005 of Figure 10); an RF circuitry interface to send/receive data to/from RF circuitry 1106 of Figure 11; a wireless hardware connectivity interface to send/receive data to/from one or more wireless hardware elements (e.g., Near Field Communication (NFC) components, Bluetooth^{®}/ Bluetooth^{®} Low Energy components, Wi-Fi^{®} components, and/or the like); and a power management interface to send/receive power or control signals to/from the PMIC 1025.

In alternate embodiments (which may be combined with the above described embodiments), baseband circuitry 1110 comprises one or more digital baseband systems, which are coupled with one another via an interconnect subsystem and to a CPU subsystem, an audio subsystem, and an interface subsystem. The digital baseband subsystems may also be coupled to a digital baseband interface and a mixed-signal baseband subsystem via another interconnect subsystem. Each of the interconnect subsystems may include a bus system, point-to-point connections, network-on-chip (NOC) structures, and/or some other suitable bus or interconnect technology, such as those discussed herein. The audio subsystem may include DSP circuitry, buffer memory, program memory, speech processing accelerator circuitry, data converter circuitry such as analog-to-digital and digital-to-analog converter circuitry, analog circuitry including one or more of amplifiers and filters, and/or other like components. In an aspect of the present disclosure, baseband circuitry 1110 may include protocol processing circuitry with one or more instances of control circuitry (not shown) to provide control functions for the digital baseband circuitry and/or radio frequency circuitry (e.g., the radio front end modules 1115).

Although not shown by Figure 11, in some embodiments, the baseband circuitry 1110 includes individual processing device(s) to operate one or more wireless communication protocols (e.g., a "multi-protocol baseband processor" or "protocol processing circuitry") and individual processing device(s) to implement PHY layer functions. In these embodiments, the PHY layer functions include the aforementioned radio control functions. In these embodiments, the protocol processing circuitry operates or implements various protocol layers/entities of one or more wireless communication protocols. In a first example, the protocol processing circuitry may operate LTE protocol entities and/or 5G/NR protocol entities when the baseband circuitry 1110 and/or RF circuitry 1106 are part of mmWave communication circuitry or some other suitable cellular communication circuitry. In the first example, the protocol processing circuitry would operate MAC, RLC, PDCP, SDAP, RRC, and NAS functions. In a second example, the protocol processing circuitry may operate one or more IEEE-based protocols when the baseband circuitry 1110 and/or RF circuitry 1106 are part of a Wi-Fi communication system. In the second example, the protocol processing circuitry would operate Wi-Fi MAC and logical link control (LLC) functions. The protocol processing circuitry may include one or more memory structures (e.g., 1104G) to store program code and data for operating the protocol functions, as well as one or more processing cores to execute the program code and perform various operations using the data. The baseband circuitry 1110 may also support radio communications for more than one wireless protocol.

The various hardware elements of the baseband circuitry 1110 discussed herein may be implemented, for example, as a solder-down substrate including one or more integrated circuits (ICs), a single packaged IC soldered to a main circuit board or a multi-chip module containing two or more ICs. In one example, the components of the baseband circuitry 1110 may be suitably combined in a single chip or chipset, or disposed on a same circuit board. In another example, some or all of the constituent components of the baseband circuitry 1110 and RF circuitry 1106 may be implemented together such as, for example, a system on a chip (SoC) or System-in-Package (SiP). In another example, some or all of the constituent components of the baseband circuitry 1110 may be implemented as a separate SoC that is communicatively coupled with and RF circuitry 1106 (or multiple instances of RF circuitry 1106). In yet another example, some or all of the constituent components of the baseband circuitry 1110 and the application circuitry 1005 may be implemented together as individual SoCs mounted to a same circuit board (e.g., a "multi-chip package").

In some embodiments, the baseband circuitry 1110 may provide for communication compatible with one or more radio technologies. For example, in some embodiments, the baseband circuitry 1110 may support communication with an E-UTRAN or other WMAN, a WLAN, a WPAN. Embodiments in which the baseband circuitry 1110 is configured to support radio communications of more than one wireless protocol may be referred to as multi-mode baseband circuitry.

RF circuitry 1106 may enable communication with wireless networks using modulated electromagnetic radiation through a non-solid medium. In various embodiments, the RF circuitry 1106 may include switches, filters, amplifiers, etc. to facilitate the communication with the wireless network. RF circuitry 1106 may include a receive signal path, which may include circuitry to down-convert RF signals received from the FEM circuitry 1108 and provide baseband signals to the baseband circuitry 1110. RF circuitry 1106 may also include a transmit signal path, which may include circuitry to up-convert baseband signals provided by the baseband circuitry 1110 and provide RF output signals to the FEM circuitry 1108 for transmission.

In some embodiments, the receive signal path of the RF circuitry 1106 may include mixer circuitry 1106a, amplifier circuitry 1106b and filter circuitry 1106c. In some embodiments, the transmit signal path of the RF circuitry 1106 may include filter circuitry 1106c and mixer circuitry 1106a. RF circuitry 1106 may also include synthesizer circuitry 1106d for synthesizing a frequency for use by the mixer circuitry 1106a of the receive signal path and the transmit signal path. In some embodiments, the mixer circuitry 1106a of the receive signal path may be configured to down-convert RF signals received from the FEM circuitry 1108 based on the synthesized frequency provided by synthesizer circuitry 1106d. The amplifier circuitry 1106b may be configured to amplify the down-converted signals and the filter circuitry 1106c may be a low-pass filter (LPF) or band-pass filter (BPF) configured to remove unwanted signals from the down-converted signals to generate output baseband signals. Output baseband signals may be provided to the baseband circuitry 1110 for further processing. In some embodiments, the output baseband signals may be zero-frequency baseband signals, although this is not a requirement. In some embodiments, mixer circuitry 1106a of the receive signal path may comprise passive mixers, although the scope of the embodiments is not limited in this respect.

In some embodiments, the mixer circuitry 1106a of the transmit signal path may be configured to up-convert input baseband signals based on the synthesized frequency provided by the synthesizer circuitry 1106d to generate RF output signals for the FEM circuitry 1108. The baseband signals may be provided by the baseband circuitry 1110 and may be filtered by filter circuitry 1106c.

In some embodiments, the mixer circuitry 1106a of the receive signal path and the mixer circuitry 1106a of the transmit signal path may include two or more mixers and may be arranged for quadrature downconversion and upconversion, respectively. In some embodiments, the mixer circuitry 1106a of the receive signal path and the mixer circuitry 1106a of the transmit signal path may include two or more mixers and may be arranged for image rejection (e.g., Hartley image rejection). In some embodiments, the mixer circuitry 1106a of the receive signal path and the mixer circuitry 1106a of the transmit signal path may be arranged for direct downconversion and direct upconversion, respectively. In some embodiments, the mixer circuitry 1106a of the receive signal path and the mixer circuitry 1106a of the transmit signal path may be configured for super-heterodyne operation.

In some embodiments, the output baseband signals and the input baseband signals may be analog baseband signals, although the scope of the embodiments is not limited in this respect. In some alternate embodiments, the output baseband signals and the input baseband signals may be digital baseband signals. In these alternate embodiments, the RF circuitry 1106 may include analog-to-digital converter (ADC) and digital-to-analog converter (DAC) circuitry and the baseband circuitry 1110 may include a digital baseband interface to communicate with the RF circuitry 1106.

In some dual-mode embodiments, a separate radio IC circuitry may be provided for processing signals for each spectrum, although the scope of the embodiments is not limited in this respect.

In some embodiments, the synthesizer circuitry 1106d may be a fractional-N synthesizer or a fractional N/N+1 synthesizer, although the scope of the embodiments is not limited in this respect as other types of frequency synthesizers may be suitable. For example, synthesizer circuitry 1106d may be a delta-sigma synthesizer, a frequency multiplier, or a synthesizer comprising a phase-locked loop with a frequency divider.

The synthesizer circuitry 1106d may be configured to synthesize an output frequency for use by the mixer circuitry 1106a of the RF circuitry 1106 based on a frequency input and a divider control input. In some embodiments, the synthesizer circuitry 1106d may be a fractional N/N+1 synthesizer.

In some embodiments, frequency input may be provided by a voltage controlled oscillator (VCO), although that is not a requirement. Divider control input may be provided by either the baseband circuitry 1110 or the application circuitry 1005 depending on the desired output frequency. In some embodiments, a divider control input (e.g., N) may be determined from a look-up table based on a channel indicated by the application circuitry 1005.

Synthesizer circuitry 1106d of the RF circuitry 1106 may include a divider, a delay-locked loop (DLL), a multiplexer and a phase accumulator. In some embodiments, the divider may be a dual modulus divider (DMD) and the phase accumulator may be a digital phase accumulator (DPA). In some embodiments, the DMD may be configured to divide the input signal by either N or N+1 (e.g., based on a carry out) to provide a fractional division ratio. In some example embodiments, the DLL may include a set of cascaded, tunable, delay elements, a phase detector, a charge pump and a D-type flip-flop. In these embodiments, the delay elements may be configured to break a VCO period up into Nd equal packets of phase, where Nd is the number of delay elements in the delay line. In this way, the DLL provides negative feedback to help ensure that the total delay through the delay line is one VCO cycle.

In some embodiments, synthesizer circuitry 1106d may be configured to generate a carrier frequency as the output frequency, while in other embodiments, the output frequency may be a multiple of the carrier frequency (e.g., twice the carrier frequency, four times the carrier frequency) and used in conjunction with quadrature generator and divider circuitry to generate multiple signals at the carrier frequency with multiple different phases with respect to each other. In some embodiments, the output frequency may be a LO frequency (fLO). In some embodiments, the RF circuitry 1106 may include an IQ/polar converter.

FEM circuitry 1108 may include a receive signal path, which may include circuitry configured to operate on RF signals received from antenna array 1111, amplify the received signals and provide the amplified versions of the received signals to the RF circuitry 1106 for further processing. FEM circuitry 1108 may also include a transmit signal path, which may include circuitry configured to amplify signals for transmission provided by the RF circuitry 1106 for transmission by one or more of antenna elements of antenna array 1111. In various embodiments, the amplification through the transmit or receive signal paths may be done solely in the RF circuitry 1106, solely in the FEM circuitry 1108, or in both the RF circuitry 1106 and the FEM circuitry 1108.

In some embodiments, the FEM circuitry 1108 may include a TX/RX switch to switch between transmit mode and receive mode operation. The FEM circuitry 1108 may include a receive signal path and a transmit signal path. The receive signal path of the FEM circuitry 1108 may include an LNA to amplify received RF signals and provide the amplified received RF signals as an output (e.g., to the RF circuitry 1106). The transmit signal path of the FEM circuitry 1108 may include a power amplifier (PA) to amplify input RF signals (e.g., provided by RF circuitry 1106), and one or more filters to generate RF signals for subsequent transmission by one or more antenna elements of the antenna array 1111.

The antenna array 1111 comprises one or more antenna elements, each of which is configured convert electrical signals into radio waves to travel through the air and to convert received radio waves into electrical signals. For example, digital baseband signals provided by the baseband circuitry 1110 is converted into analog RF signals (e.g., modulated waveform) that will be amplified and transmitted via the antenna elements of the antenna array 1111 including one or more antenna elements (not shown). The antenna elements may be omnidirectional, direction, or a combination thereof. The antenna elements may be formed in a multitude of arranges as are known and/or discussed herein. For example, the antenna array 1111 may include one or more of the antenna assemblies described herein. In some embodiments, the antenna array 1111 may comprise metal strip (e.g., slot) antennas that are at least partially formed by a housing of the computing platform (e.g., platform 1000). The antenna array 1111 may comprise microstrip antennas or printed antennas that are fabricated on the surface of one or more printed circuit boards (e.g., rigid and/or flexible printed circuit boards). The antenna array 1111 may be formed in as a patch of metal foil (e.g., a patch antenna) in a variety of shapes, and may be coupled with the RF circuitry 1106 and/or FEM circuitry 1108 using metal transmission lines or the like.

Processors of the application circuitry 1005 and processors of the baseband circuitry 1110 may be used to execute elements of one or more instances of a protocol stack. For example, processors of the baseband circuitry 1110, alone or in combination, may be used execute Layer 3, Layer 2, or Layer 1 functionality, while processors of the application circuitry 1005 may utilize data (e.g., packet data) received from these layers and further execute Layer 4 functionality (e.g., TCP and UDP layers). As referred to herein, Layer 3 may comprise a RRC layer, described in further detail below. As referred to herein, Layer 2 may comprise a MAC layer, an RLC layer, and a PDCP layer, described in further detail below. As referred to herein, Layer 1 may comprise a PHY layer of a UE/RAN node, described in further detail below.

### EXAMPLES

The invention is set out in the appended set of claims. Some illustrative Examples of various embodiments are provided below.

Example 1 includes an antenna assembly including: a metal chassis, a ground plane, a first antenna coupled to a ground plane; a second antenna coupled to the ground plane; and an isolation network coupled to the ground plane between the first and second antennas. The isolation network includes: a conductive structure; and an isolation circuit coupled between the conductive structure and the ground plane, wherein the isolation circuit includes a resistor and a capacitor. The conductive structure includes: a first portion that is between the first antenna and the second antenna; and a second portion to conductively couple the first portion to the isolation circuit, wherein a width of the first portion is greater than a width of the second portion. At least a part of each of the respective first antenna, the second antenna, and the conductive structure is implemented by a chassis of an electronic device.

Example 2 is the antenna assembly of Example 1, wherein the isolation circuit further includes an inductor, and wherein the resistor, the capacitor, and the inductor are coupled in parallel with one another and coupled between the conductive structure and the ground plane.

**.**

Example 3 is the antenna assembly of Example 3, wherein the second portion and the isolation circuit are included on a flexible printed circuit board.

Example 4 is the antenna assembly of Example 1, wherein the inductor is a first inductor, wherein the capacitor is a first capacitor, and wherein the first antenna includes a feed network comprising: a feed element to pass a radio frequency (RF) signal to or from a conductive antenna portion of the first antenna; a second inductor coupled between the feed element and an internal node of the feed network; and a second capacitor coupled between the internal node and the ground plane.

Example 5 is the antenna assembly of Example 6, wherein the first antenna further includes a third capacitor coupled between the internal node and the conductive antenna portion.

Example 6 is the antenna assembly of Example 1, wherein the inductor is a first inductor, wherein the capacitor is a first capacitor, and wherein the first antenna includes a feed network comprising: a feed element to pass a radio frequency (RF) signal to or from a conductive antenna portion of the first antenna; a second capacitor coupled between the feed element and an internal node of the feed network; and a second inductor coupled between the internal node and the ground plane.

Example 7 is the antenna assembly of Example 8, further comprising a tuner circuit to control an inductance of the second inductor.

Example 8 is the antenna assembly of Example 9, wherein the tuner circuit is a first tuner circuit, and wherein the antenna assembly further includes: an impedance matching circuit coupled to the conductive antenna portion of the first antenna; and a second tuner circuit to control an impedance characteristic of the impedance matching circuit.

Example 9 is the antenna assembly of Example 1, wherein the first antenna and the second antenna have respective conductive antenna portions with different configurations.

Example 10 is the antenna assembly of Example 1, wherein the first antenna includes a parting line adjacent to a conductive antenna portion of the first antenna, wherein the parting line is a non-conductive material and at least partially defines a shape of the conductive antenna portion.

Example 11 is an antenna assembly comprising: a conductive antenna portion to transmit or receive a radio frequency (RF) signal; and a feed network coupled between the conductive antenna portion and a ground plane. The feed network includes: a feed element to pass the RF signal to or from the conductive antenna portion; a first selected one of a capacitor or an inductor coupled between the feed element and an internal node of the feed network; and a second selected one of the capacitor or the inductor coupled between the internal node and the ground plane.

Example 12 is the antenna assembly of Example 11, wherein the capacitor is a first capacitor, and wherein the feed network further includes a second capacitor coupled between the internal node and the conductive antenna portion.

Example 13 is the antenna assembly of Example 11, further comprising a tuner circuit to control an inductance of the inductor.

Example 14 is the antenna assembly of Example 11, wherein the first selected one is the capacitor and the second selected one is the inductor.

Example 15 is the antenna assembly of Example 11, wherein the first selected one is the inductor and the second selected one is the capacitor.

Example 16 is the antenna assembly of Example 11, wherein the conductive antenna portion and the feed network are included in a first antenna, and wherein the antenna assembly further includes: a second antenna coupled to the ground plane; and an isolation network coupled to the ground plane between the first and second antennas. The isolation network includes: a conductive stub between the conductive antenna portion of the first antenna and a conductive antenna portion of the second antenna; and an isolation circuit coupled between the conductive stub and the ground plane, wherein the isolation circuit includes a resistor and a capacitor coupled in parallel with one another.

Example 17 is a computer system including: an antenna assembly and one or more processors coupled to the antenna assembly to communicate over one or more wireless networks via the antenna assembly. The antenna assembly includes: a first antenna coupled to a ground plane and including a first conductive antenna portion to transmit or receive a first radio frequency (RF) signal; a second antenna coupled to the ground plane and including a second conductive antenna portion to transmit or receive the second RF signal; and an isolation network coupled to the ground plane between the first and second antennas. The isolation circuit includes: a conductive structure coupled between the first and second conductive antenna portions; and an isolation circuit with a resistor and a capacitor coupled in parallel with one another and coupled between the conductive structure and the ground plane

Example 18 is the computer system of Example 17, wherein the conductive structure includes: a first portion that is between the first and second conductive antenna portions; and a second portion to conductively couple the first portion to the isolation circuit, wherein a width of the first portion is greater than a width of the second portion.

Example 19 is the computer system of Example 18, wherein the second portion and the isolation circuit are included on a flexible printed circuit board.

Example 20 is the computer system of Example 17, wherein at least a part of each of the respective first conductive antenna portion, the second conductive antenna portion, and the conductive structure is implemented by a chassis of the computer system.

Example 21 is the computer system of Example 17, wherein the first antenna further includes a feed network coupled between the first conductive antenna portion and a ground plane, wherein the feed network includes: a feed element to pass the first RF signal to or from the first conductive antenna portion; a first selected one of a second capacitor or an second inductor coupled between the feed element and an internal node of the feed network; and a second selected one of the second capacitor or the second inductor coupled between the internal node and the ground plane.

Example 22 is the computer system of Example 21, wherein the feed network further includes a third capacitor coupled between the internal node and the conductive antenna portion.

Example 23 is the computer system of Example 17, wherein the isolation circuit further includes an inductor coupled in parallel with the resistor and the capacitor.

Although certain embodiments have been illustrated and described herein for purposes of description, this application is intended to cover any adaptations or variations of the embodiments discussed herein. Therefore, the specification is not meant to limit the disclosure. Rather, the scope of the disclosure is defined only in accordance with the following claims.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

## Claims

1. An antenna assembly (100, 600) comprising:
a metal chassis (636) of an electronic device;
a ground plane (106);
a first antenna (102, 602) coupled to the ground plane (106);
a second antenna (104, 604) coupled to the ground plane (106); and
an isolation network (108, 608) coupled to the ground plane (106) between the first antenna (102, 602) and the second antenna (104, 604), wherein the isolation network (108, 608) includes:
a conductive structure (118, 618); and
an isolation circuit (120, 620) coupled between the conductive structure (118, 618) and the ground plane (106), wherein the isolation circuit (120, 620) includes a resistor (126) and a capacitor (130);
wherein the conductive structure (118, 618) includes:
a first portion (122) that is between the first antenna (102, 602) and the second antenna (104, 604); and
a second portion (124) to conductively couple the first portion (122) to the isolation circuit (120, 620), wherein a width of the first portion (122) is greater than a width of the second portion (124); and
wherein at least a part of each of the first antenna (102, 602) and the second antenna (104, 604) is implemented by the metal chassis (636), and wherein the
conductive structure (118, 618) is implemented by a portion of the metal chassis (636).

2. The antenna assembly (100, 600) of claim 1, wherein the isolation circuit (120, 620) further includes an inductor (128), and wherein the resistor (126), the capacitor (130), and the inductor (128) are coupled in parallel with one another and coupled between the conductive structure (118, 618) and the ground plane (106).

3. The antenna assembly (100, 600) of claim 1, wherein the isolation circuit (120, 620) is included on a flexible printed circuit board.

4. The antenna assembly (100) of any one of claims 2-3, wherein the inductor (128) is a first inductor (128), wherein the capacitor (130) is a first capacitor (130), and wherein the first antenna (102) includes a feed network (312a) comprising:
a feed element (338a) to pass a radio frequency, RF, signal to or from a conductive antenna portion (110) of the first antenna (102);
a second inductor (340a) coupled between the feed element (338a) and an internal node (342a) of the feed network (312a); and
a second capacitor (344a) coupled between the internal node (342a) and the ground plane (346a).

5. The antenna assembly (100) of claim 4, wherein the first antenna (102) further includes a third capacitor (348a) coupled between the internal node (342a) and the conductive antenna portion (110).

6. The antenna assembly (100) of any one of claims 2-3, wherein the inductor (128) is a first inductor (128), wherein the capacitor (130) is a first capacitor (130), and wherein the first antenna (102) includes a feed network (312c) comprising:
a feed element (338c) to pass a radio frequency, RF, signal to or from a conductive antenna portion (110) of the first antenna (102);
a second capacitor (344c) coupled between the feed element (338c) and an internal node (342c) of the feed network (312c); and
a second inductor (340c) coupled between the internal node (342c) and the ground plane (346c).

7. The antenna assembly (100) of claim 6, further comprising a tuner circuit to control an inductance of the second inductor (340c).

8. The antenna assembly (100) of claim 7, wherein the tuner circuit is a first tuner circuit, and wherein the antenna assembly (100) further includes:
an impedance matching circuit coupled to the conductive antenna portion (110) of the first antenna (102); and
a second tuner circuit to control an impedance characteristic of the impedance matching circuit.

9. The antenna assembly (100) of any one of claims 1-8, wherein the first antenna (102) and the second antenna (104) have respective conductive antenna portions (110, 114) with different configurations.

10. The antenna assembly (100) of any one of claims 1-9, wherein the first antenna (102) includes a parting line adjacent to a conductive antenna portion (110) of the first antenna (102), wherein the parting line is a non-conductive material and at least partially defines a shape of the conductive antenna portion (110).

11. A computer system (550) comprising:
the antenna assembly (100) of any one of claims 1-10; and
one or more processors coupled to the antenna assembly (100) to communicate over one or more wireless networks via the antenna assembly (100).

## Patentansprüche

1. Antennenanordnung (100, 600), umfassend:
ein Metallgehäuse (636) einer elektronischen Vorrichtung;
eine Masseebene (106);
eine erste Antenne (102, 602), die mit der Masseebene (106) gekoppelt ist;
eine zweite Antenne (104, 604), die mit der Masseebene (106) gekoppelt ist; und
ein Isolationsnetzwerk (108, 608), das mit der Masseebene (106) zwischen der ersten Antenne (102, 602) und der zweiten Antenne (104, 604) gekoppelt ist, wobei das Isolationsnetzwerk (108, 608) Folgendes beinhaltet:
eine leitfähige Struktur (118, 618); und
eine Isolationsschaltung (120, 620), die zwischen der leitfähigen Struktur (118, 618) und der Masseebene (106) gekoppelt ist, wobei die Isolationsschaltung (120, 620) einen Widerstand (126) und einen Kondensator (130) beinhaltet;
wobei die mehreren leitfähigen Strukturen (118, 618) Folgendes beinhalten:
einen ersten Teil (122), der sich zwischen der ersten Antenne (102, 602) und der zweiten Antenne (104, 604) befindet; und
einen zweiten Teil (124) zum leitfähigen Koppeln des ersten Teils (122) mit der Isolationsschaltung (120, 620), wobei eine Breite des ersten Teils (122) größer als eine Breite des zweiten Teils (124) ist; und
wobei wenigstens ein Teil sowohl der ersten Antenne (102, 602) als auch der zweiten Antenne (104, 604) durch das Metallgehäuse (636) implementiert ist und wobei die leitfähige Struktur (118, 618) durch einen Teil des Metallgehäuses (636) implementiert ist.

2. Antennenbaugruppe (100, 600) nach Anspruch 1, wobei die Isolationsschaltung (120, 620) ferner einen Induktor (128) beinhaltet und wobei der Widerstand (126), der Kondensator (130) und der Induktor (128) parallel miteinander gekoppelt und zwischen der leitfähigen Struktur (118, 618) und der Masseebene (106) gekoppelt sind.

3. Antennenanordnung (100, 600) nach Anspruch 1, wobei die Isolationsschaltung (120, 620) auf einer flexiblen Leiterplatte enthalten ist.

4. Antennenanordnung (100) nach einem der Ansprüche 2-3, wobei der Induktor (128) ein erster Induktor (128) ist, wobei der Kondensator (130) ein erster Kondensator (130) ist und wobei die erste Antenne (102) ein Speisenetzwerk (312a) beinhaltet, das Folgendes umfasst:
ein Speiseelement (338a) zum Weiterleiten eines Hochfrequenz-, HF-, Signals zu oder von einem leitfähigen Antennenteil (110) der ersten Antenne (102);
einen zweiten Induktor (340a), der zwischen dem Speiseelement (338a) und einem internen Knoten (342a) des Speisenetzwerks (312a) gekoppelt ist; und
einen zweiten Kondensator (344a), der zwischen dem internen Knoten (342a) und der Masseebene (346a) gekoppelt ist.

5. Antennenanordnung (100) nach Anspruch 4, wobei die erste Antenne (102) ferner einen dritten Kondensator (348a) beinhaltet, der zwischen dem internen Knoten (342a) und dem leitfähigen Antennenteil (110) gekoppelt ist.

6. Antennenanordnung (100) nach einem der Ansprüche 2-3, wobei der Induktor (128) ein erster Induktor (128) ist, wobei der Kondensator (130) ein erster Kondensator (130) ist und wobei die erste Antenne (102) ein Speisenetzwerk (312c) beinhaltet, das Folgendes umfasst:
ein Speiseelement (338c) zum Weiterleiten eines Hochfrequenz-, HF-, Signals zu oder von einem leitfähigen Antennenteil (110) der ersten Antenne (102);
einen zweiten Kondensator (344c), der zwischen dem Speiseelement (338c) und einem internen Knoten (342c) des Speisenetzwerks (312c) gekoppelt ist; und
einen zweiten Induktor (340c), der zwischen dem internen Knoten (342c) und der Masseebene (346c) gekoppelt ist.

7. Antennenanordnung (100) nach Anspruch 6, ferner umfassend eine Abstimmschaltung zum Steuern einer Induktivität des zweiten Induktors (340c).

8. Antennenanordnung (100) nach Anspruch 7, wobei die Abstimmschaltung eine erste Abstimmschaltung ist und wobei die Antennenanordnung (100) ferner Folgendes beinhaltet:
eine Impedanzabgleichschaltung, die mit dem leitfähigen Antennenteil (110) der ersten Antenne (102) gekoppelt ist; und
eine zweite Abstimmschaltung zum Steuern einer Impedanzcharakteristik der Impedanzabgleichschaltung.

9. Antennenanordnung (100) nach einem der Ansprüche 1-8, wobei die erste Antenne (102) und die zweite Antenne (104) jeweilige leitfähige Antennenteile (110, 114) mit unterschiedlichen Konfigurationen aufweisen.

10. Antennenanordnung (100) nach einem der Ansprüche 1-9, wobei die erste Antenne (102) eine Trennlinie neben einem leitfähigen Antennenteil (110) der ersten Antenne (102) beinhaltet, wobei die Trennlinie ein nichtleitfähigen Material ist und wenigstens teilweise eine Form des leitfähigen Antennenteils (110) definiert.

11. Computersystem (550), umfassend:
die Antennenanordnung (100) nach einem der Ansprüche 1-10; und
einen oder mehrere Prozessoren, die mit der Antennenanordnung (100) gekoppelt sind, um über ein oder mehrere Drahtlosnetzwerke über die Antennenanordnung (100) zu kommunizieren.

## Revendications

1. Ensemble antenne (100, 600) comprenant :
un châssis métallique (636) d'un équipement électronique ;
un plan de masse (106) ;
une première antenne (102, 602) couplée au plan de masse (106) ;
une seconde antenne (104, 604) couplée au plan de masse (106) ; et
un réseau d'isolation (108, 608) couplé au plan de masse (106) entre la première antenne (102, 602) et la seconde antenne (104, 604), dans lequel le réseau d'isolation (108, 608) comprend :
une structure conductrice (118, 618) ; et
un circuit d'isolation (120, 620) couplé entre la structure conductrice (118, 618) et le plan de masse (106), dans lequel le circuit d'isolation (120, 620) comprend une résistance (126) et un condensateur (130) ;
la structure conductrice (118, 618) comprenant :
une première partie (122) comprise entre la première antenne (102, 602) et la seconde antenne (104, 604) ; et
une seconde partie (124) destinée à coupler de manière conductrice la première partie (122) au circuit d'isolation (120, 620), la largeur de la première partie (122) étant supérieure à la largeur de la seconde partie (124) ; et
dans lequel au moins une partie de chacune de la première antenne (102, 602) et de la seconde antenne (104, 604) est mise en œuvre par le châssis métallique (636), et dans lequel la structure conductrice (118, 618) est mise en œuvre par une partie du châssis métallique (636).

2. Ensemble antenne (100, 600) selon la revendication 1, dans lequel le circuit d'isolation (120, 620) comprend en outre un inducteur (128), et dans lequel la résistance (126), le condensateur (130) et l'inducteur (128) sont couplés en parallèle l'un avec l'autre et couplés entre la structure conductrice (118, 618) et le plan de masse (106).

3. Ensemble antenne (100, 600) selon la revendication 1, dans lequel le circuit d'isolation (120, 620) est inclus sur une carte de circuit imprimé flexible.

4. Ensemble antenne (100) selon l'une quelconque des revendications 2 et 3, dans lequel l'inducteur (128) est un premier inducteur (128), dans lequel le condensateur (130) est un premier condensateur (130) et dans lequel la première antenne (102) comprend un réseau d'alimentation (312a) comprenant :
un élément d'alimentation (338a) pour faire passer un signal radiofréquence, RF, vers ou depuis une partie d'antenne conductrice (110) de la première antenne (102) ;
un second inducteur (340a) couplé entre l'élément d'alimentation (338a) et un nœud interne (342a) du réseau d'alimentation (312a) ; et
un deuxième condensateur (344a) couplé entre le nœud interne (342a) et le plan de masse (346a).

5. Ensemble antenne (100) selon la revendication 4, dans lequel la première antenne (102) comprend en outre un troisième condensateur (348a) couplé entre le nœud interne (342a) et la partie d'antenne conductrice (110).

6. Ensemble antenne (100) selon l'une quelconque des revendications 2 et 3, dans lequel l'inducteur (128) est un premier inducteur (128), dans lequel le condensateur (130) est un premier condensateur (130) et dans lequel la première antenne (102) comprend un réseau d'alimentation (312c) comprenant :
un élément d'alimentation (338c) pour faire passer un signal radiofréquence, RF, vers ou depuis une partie d'antenne conductrice (110) de la première antenne (102) ;
un second condensateur (344c) couplé entre l'élément d'alimentation (338c) et un nœud interne (342c) du réseau d'alimentation (312c) ; et
un second inducteur (340c) couplé entre le nœud interne (342c) et le plan de masse (346c).

7. Ensemble antenne (100) selon la revendication 6, comprenant en outre un circuit syntoniseur pour commander une inductance du second inducteur (340c).

8. Ensemble antenne (100) selon la revendication 7, dans lequel le circuit syntoniseur est un premier circuit syntoniseur, et dans lequel l'ensemble antenne (100) comprend en outre :
un circuit d'adaptation d'impédance couplé à la partie d'antenne conductrice (110) de la première antenne (102) ; et
un second circuit syntoniseur pour commander une caractéristique d'impédance du circuit d'adaptation d'impédance.

9. Ensemble antenne (100) selon l'une quelconque des revendications 1 à 8, dans lequel la première antenne (102) et la seconde antenne (104) possèdent des parties d'antenne conductrice respectives (110, 114) présentant des configurations différentes.

10. Ensemble antenne (100) selon l'une quelconque des revendications 1 à 9, dans lequel la première antenne (102) comprend une ligne de séparation adjacente à une partie d'antenne conductrice (110) de la première antenne (102), dans lequel la ligne de séparation est un matériau non conducteur et définit au moins partiellement une forme de la partie d'antenne conductrice (110).

11. Système informatique (550), comprenant :
l'ensemble antenne (100) selon l'une quelconque des revendications 1 à 10 ; et
un ou plusieurs processeurs couplés à l'ensemble antenne (100) pour communiquer sur un ou plusieurs réseaux sans fil par le biais de l'ensemble antenne (100).
